# FASCICULE DE BREVET EUROPEEN

(11) **EP 2 259 320 B1**
(45) Date de publication et mention de la délivrance du brevet: **20.06.2012**
(21) Numéro de dépôt: 10305521.6
(22) Date de dépôt: 18.05.2010
(51) Int. Cl.: H01L 27/20, H01L 41/113

(54) **Procédé de génération d'énergie électrique dans un circuit intégré, circuit intégré correspondant et procédé de fabrication.**
Verfahren zur Erzeugung von elektrischer Energie in einem integrierten Schaltkreis, entsprechender integrierter Schaltkreis und Herstellungsverfahren
Method for generating electric energy in an integrated circuit, corresponding integrated circuit and manufacturing method.

(30) Priorité: 04.06.2009 FR 0953702
(43) Date de publication de la demande: 08.12.2010
(73) Titulaire: STMicroelectronics (Rousset) SAS, 13790 Rousset (FR); Universite Aix-Marseille I, 13331 Marseille Cedex 3 (FR)
(72) Inventeur: Schwarz, Christian, 1418 Vuarrens (CH); Monserie, Christophe, 13290 Les Milles (FR); Delalleau, Julien, 13090 Aix en Provence (FR)
(74) Mandataire: Zapalowicz, Francis

(56) Documents cités:
- EP-A2- 1 317 056
- JP-A- 2003 061 368
- US-A1- 2003 006 668

## Description

L'invention concerne les circuits intégrés, et plus particulièrement la génération d'énergie électrique dans un circuit intégré autre que celle produite par une alimentation classique comme par exemple une batterie.

La demande européenne EP 1 317 056 (D1) divulgue un générateur de type oscillant comportant un élément de générateur générant de l'électricité en faisant heurter des éléments piézo-électriques par un élément d'impact, cet élément de générateur étant solidaire d'un élément élastique qui, sous l'action d'une force externe, provoque l'oscillation de l'élément de générateur et donc des chocs de l'élément d'impact contre les éléments piézo-électriques.

Selon un mode de mise en oeuvre et de réalisation, il est ainsi proposé d'utiliser un mouvement erratique d'objets tridimensionnels, par exemple des objets en forme de bille, ou plus généralement en forme de patatoïde, au sein d'une ou de plusieurs enceintes closes contenant chacune un ou plusieurs éléments piézo-électriques, et d'utiliser les chocs de ces objets sur ces éléments piézo-électriques pour produire à chaque choc une impulsion électrique qui pourra être utilisée pour alimenter au moins une partie du circuit intégré ou bien recharger une micro-batterie, ou bien encore être stockée dans un moyen de stockage tel qu'un condensateur pour ensuite être réutilisée.

Ainsi, il devient possible de prolonger par exemple la durée de vie de la batterie ou bien éventuellement de rendre le dispositif autoalimenté sans qu'il soit nécessaire de l'équiper d'une batterie.

Selon un mode de mise en oeuvre et de réalisation, une telle mise en mouvement des billes au sein des enceintes peut s'effectuer de différentes façons. A titre d'exemple non limitatif, on peut citer des vibrations d'origines acoustiques ou autres, ou bien le mouvement du circuit intégré placé sur un support lui-même en mouvement.

L'invention trouve ainsi de nombreuses applications, par exemple et de façon non limitative, dans le domaine de la santé pour l'alimentation et/ou la prolongation de la durée de vie d'une batterie d'un capteur surveillant le rythme cardiaque d'un être humain et placé par exemple au voisinage du coeur de celui-ci (le mouvement du coeur provoquant la mise en mouvement erratique des billes dans les logements). On peut également citer des capteurs de détection de passage de voitures sur un pont, le passage de la voiture faisant vibrer le pont sur lequel est placé le capteur et provoquant donc une mise en mouvement des billes dans le logement et la production d'un signal électrique pouvant servir à autoalimenter le capteur ou éventuellement à générer un signal de détection.

On peut encore citer une application à la surveillance du fonctionnement d'une pompe à eau d'un véhicule qui vibre en fonctionnement et qui va donc permettre la mise en mouvement des billes dans le logement et provoquer la génération d'une énergie électrique dans le capteur.

Selon un mode de mise en oeuvre et de réalisation, il est proposé un procédé de génération d'énergie électrique dans un circuit intégré et un circuit intégré capable de fonctionner avec une bande passante fréquentielle large et indépendamment de la direction des mouvements d'un support sur lequel serait placé le circuit intégré.

Selon un aspect, il est proposé un procédé de génération d'énergie électrique dans un circuit intégré, ce procédé comprenant une mise en mouvement relatif d'au moins d'un espace clos tridimensionnel ménagé au sein dudit circuit intégré et contenant au moins un élément piézo-électrique, et d'au moins un objet logé de façon libre à l'intérieur du ou de chaque espace clos tridimensionnel, et une production d'énergie électrique résultant d'au moins un choc entre l'objet ou l'un au moins des objets et l'élément piézo-électrique ou l'un au moins des éléments piézo-électriques lors dudit mouvement relatif.

Par espace clos tridimensionnel, il faut entendre tout moyen, par exemple une boîte ou une cage, ajourée ou non, permettant d'empêcher les objets, généralement tridimensionnels, de sortir de l'espace clos lors de leurs mouvements.

Par ailleurs, un objet logé libre dans un tel espace clos, a la faculté de pouvoir se mouvoir librement dans n'importe quelle direction de l'espace, généralement de façon erratique, compte tenu éventuellement des chocs sur les différentes parois du logement, lors de la mise en mouvement relatif de l'espace clos et de l'objet.

L'utilisation d'un espace tridimensionnel en combinaison avec des objets, généralement tridimensionnels, par exemple en forme de patatoïdes, permet un fonctionnement qui n'est pas limité à une direction particulière de la mise en mouvement et qui s'adapte donc à tout type de mouvements auxquels serait soumis le circuit intégré. Par ailleurs, l'utilisation de ces objets pouvant se mouvoir de façon erratique dans l'espace clos pour venir frapper le ou les éléments piézo-électriques, est totalement indépendant d'une quelconque fréquence de mouvement et/ou de fréquence de fonctionnement de l'élément piézo-électrique ce qui permet d'offrir un procédé capable de produire de l'énergie dans un circuit intégré dont les fréquences éventuelles des mouvements peuvent être très variées.

Bien entendu, la taille des objets et/ou leur nombre ainsi que le volume de l'espace clos et/ou leur nombre, seront adaptés en fonction des applications.

Ainsi, il est possible de loger plusieurs objets de façon libre dans l'espace clos ou dans au moins l'un des espaces clos, et la production d'énergie résulte alors de chaque choc d'au moins un objet sur au moins un élément piézo-électrique à l'intérieur de l'espace clos ou de l'un au moins des espaces clos.

Il est également possible qu'au moins un espace clos contienne plusieurs éléments piézo-électriques et la production d'énergie électrique résulte de chaque choc d'au moins un objet sur au moins un élément piézo-électrique à l'intérieur de l'espace clos ou de l'un au moins des espaces clos.

En fait, pour un espace clos, la quantité d'énergie produite va dépendre du nombre de chocs, et par conséquent du nombre d'objets et/ou du nombre d'éléments piézo-électriques dans cet espace clos. L'homme du métier saura ajuster ces paramètres en fonction de l'application envisagée.

Bien entendu, de façon à ce que les objets puissent se déplacer librement dans l'espace clos, il faut que la somme de leur volume soit inférieure au volume libre disponible dans l'espace clos. Cela étant, il est préférable d'avoir une somme de volume des objets bien inférieure au volume libre de façon à pouvoir donner plus de liberté de mouvement aux objets et leur permettre donc d'aller frapper plus facilement le ou les éléments piézo-électriques.

Là encore, l'homme du métier saura ajuster ces paramètres en fonction de l'application envisagée. Cela étant, à titre indicatif, la somme du volume des objets dans un espace clos peut être par exemple supérieure au dixième du volume intérieur libre de l'espace clos et inférieure au quart de ce volume intérieur libre.

De même, la taille des objets à l'intérieur d'un même espace clos peut être identique ou différente. Le fait d'utiliser des tailles différentes permet d'augmenter encore la bande passante du dispositif et peut éviter ainsi par exemple d'avoir une répartition gaussienne centrée sur une seule fréquence.

La taille des objets peut être également différente d'un espace clos à un autre.

De même, la taille et/ou la forme des éléments piézo-électriques peut être identique ou différente d'un espace clos à un autre ou au sein d'un même espace clos.

Selon un mode de mise en oeuvre, on fixe au moins un élément piézo-électrique au voisinage d'au moins une partie d'une paroi de l'espace clos ou de l'un au moins des espaces clos de façon à ce que le ou les objets soient logés de façon libre entre le ou les éléments piézo-électriques et les autres parois de l'espace clos.

Selon un autre mode de mise en oeuvre, il est également possible de fixer au moins un premier élément piézo-électrique au voisinage d'au moins une partie d'une première paroi, par exemple une paroi inférieure, de l'espace clos ou de l'un au moins des espaces clos et de fixer au moins un deuxième piézo-électrique au voisinage d'au moins une partie d'une deuxième paroi de cet espace clos, par exemple une paroi supérieure, de façon à ce que les objets soient logés de façon libre entre le ou les premiers éléments piézo-électriques, le ou les deuxièmes éléments piézo-électriques, et les autres parois de l'espace clos, par exemple la paroi latérale. Une telle configuration permet d'augmenter encore le nombre de chocs possibles et donc d'augmenter la quantité d'énergie électrique produite.

En variante, au moins une des parois elle-même de l'espace clos pourrait être formée d'un matériau piézo-électrique pour autant que l'épaisseur de la paroi ainsi que la taille et le poids des objets permettent une déformation de ce matériau lors d'un impact de l'objet sur cette paroi.

Bien entendu, les surfaces du ou des éléments piézo-électriques et/ou du ou des parois formant éventuellement élément piézo-électrique, peuvent être de toutes formes (planes, rugueuses, ondulées, en biais etc...).

On ménage avantageusement le ou les espaces clos au-dessus d'un niveau de métallisation du circuit intégré, c'est-à-dire dans la partie du circuit intégré comportant les interconnexions métalliques et communément désigné par l'homme du métier sous la dénomination anglo-saxonne de « back-end-of-line » (BEOL).

On peut par exemple utiliser en continu l'énergie produite par les chocs des objets sur les éléments piézo-électriques pour par exemple recharger une batterie alimentant le circuit intégré. Cela étant, il est également possible de stocker l'énergie électrique produite dans un moyen de stockage ménagé dans le circuit intégré, par exemple un condensateur, qui pourra ensuite être déchargé en totalité ou en partie pour alimenter tout ou partie des éléments actifs du circuit intégré.

La mise en mouvement relatif du ou des logements et du ou des objets peut résulter de l'occurrence d'un évènement externe au circuit intégré interagissant directement ou à distance avec ledit circuit intégré.

Une interaction directe se produit par exemple lorsqu'on place le circuit intégré sur un support qui est destiné à bouger.

Une interaction à distance peut par exemple résulter d'une onde acoustique provoquée par l'occurrence d'un évènement, cette onde acoustique, lorsqu'elle est reçue au niveau du logement provoquant ladite mise en mouvement relatif du ou des espaces clos (ou logements) et des objets.

Un exemple d'application se situe dans la détection d'effractions. Par exemple, si un capteur intégrant le circuit intégré est placé sur une ouverture, par exemple une baie vitrée, le fait de fracturer la baie vitrée va engendrer des vibrations qui vont mettre en mouvement relatif les billes et le logement et par conséquent générer une production électrique qui pourra par exemple utilisée pour émettre un signal de détection.

Ainsi, selon un autre aspect, il est proposé un procédé de détection de l'occurrence d'un évènement externe au circuit intégré, comprenant un procédé de génération d'énergie dans le circuit intégré tel que défini ci-avant, ladite mise en mouvement relatif étant provoquée par une action résultant de ladite occurrence, et le procédé de détection comprend l'émission d'un signal généré à partir de ladite production d'énergie.

Selon un autre aspect, il est proposé un circuit intégré, comprenant au moins un espace clos tridimensionnel ménagé au sein dudit circuit intégré et contenant au moins un élément piézo-électrique, au moins un objet logé de façon libre dans l'espace clos ou chaque espace clos tridimensionnel, et des moyens de sortie électriquement conducteurs, couplés au ou aux éléments piézo-électriques, et configurés pour délivrer une énergie électrique résultant d'au moins un choc entre l'objet ou l'un au moins des objets et l'élément piézo-électrique ou l'un au moins des éléments piézo-électriques lors d'un mouvement relatif du ou des objets et de l'espace clos ou des espace clos correspondants.

Selon un mode de réalisation, plusieurs objets sont logés de façon libre dans l'espace clos ou dans l'un au moins des espaces clos.

Selon un mode de réalisation, l'espace clos ou l'un au moins des espaces clos contient plusieurs éléments piézo-électriques.

Selon un autre mode de réalisation, au moins un élément piézo-électrique est fixé au voisinage d'au moins une partie d'une première paroi de l'espace clos ou de l'un au moins des espaces clos de façon à ce que le ou les objets soient logés de façon libre entre le ou les éléments piézo-électriques et les autres parois de l'espace clos.

Selon un autre mode de réalisation, au moins un premier élément piézo-électrique est fixé au voisinage d'au moins une partie d'une première paroi de l'espace clos ou de l'un au moins des espaces clos et au moins un deuxième élément piézo-électrique est fixé au voisinage d'au moins une partie d'une deuxième paroi dudit espace clos de façon à ce que le ou les objets soient logés de façon libre entre le ou les premiers éléments piézo-électriques, le ou les deuxièmes éléments piézo-électriques et les autres parois dudit espace clos.

Au moins un élément piézo-électrique peut comporter au moins une poutre montée en cantilever et formée d'au moins un matériau piézo-électrique.

En variante, au moins un élément piézo-électrique peut comporter un ensemble monobloc comportant plusieurs poutres, chaque poutre étant montée en cantilever et formée d'au moins un matériau piézo-électrique.

Selon un mode de réalisation, la ou les poutres montées en cantilever sont montées à distance de ladite première paroi de façon à former un tapis piézo-électrique ajouré disposé en regard de ladite première paroi, les espaces ajourés du tapis ayant une taille inférieure à la taille de chaque objet.

A titre indicatif, dans le cas où les objets sont sensiblement en forme de bille, on peut prévoir des espaces ajourés ayant une taille de l'ordre de la moitié du diamètre des billes.

Selon un autre mode de réalisation, au moins un élément piézo-électrique comporte une plaque ajourée fixée par ses bords dans au moins un espace clos de façon à pouvoir se déformer dans une direction orthogonale à sa surface, ladite plaque étant formée d'au moins un matériau piézo-électrique, les espaces ajourés de la plaque ayant une taille inférieure à la taille de chaque objet.

Le tapis de poutre et ladite plaque ajourée peuvent ainsi être disposés avantageusement en regard l'une de l'autre, le ou les objets étant logés de façon libre entre le tapis et la plaque.

La taille de chaque objet peut être une taille au plus micrométrique, voire une taille nanométrique.

Le ou les espaces clos peuvent être disposés avantageusement au-dessus d'un niveau de métallisation du circuit intégré, c'est-à-dire dans la partie « back-end-of-line » du circuit intégré.

Le circuit intégré peut comprendre en outre un moyen de stockage, couplé au moyen de sorties électriques, et configuré pour stocker l'énergie produite.

Selon un autre aspect, il est proposé un dispositif de détection de l'occurrence d'un évènement, ce dispositif de détection comprenant un circuit intégré tel que défini ci-avant, agencé pour recevoir un signal incident, par exemple une vibration, résultant de ladite occurrence et capable de provoquer ladite mise en mouvement relatif, et de moyens d'émission configurés pour délivrer un signal de sortie généré à partir de l'énergie délivrée par les moyens de sortie du circuit intégré.

Ainsi, un tel capteur peut être éventuellement complètement dépourvu d'alimentation électrique et c'est l'occurrence de l'évènement qui va provoquer la mise en mouvement relatif du logement et des billes et délivrer l'énergie nécessaire pour l'émission d'un signal de détection, par exemple infrarouge ou radiofréquence.

Selon un autre aspect, il est proposé un procédé de fabrication d'un circuit intégré comprenant une réalisation d'une partie active du circuit intégré, communément désignée par l'homme du métier sous la dénomination anglo-saxonne de « front-end-of-line » (FEOL), et une réalisation d'une partie d'interconnexion au-dessus de la partie active, communément par l'homme du métier sous la dénomination anglo-saxonne de « back-end-of-line » (BEOL).

Selon une caractéristique générale de cet aspect, le procédé de fabrication comprend en outre, lors de la réalisation de la partie d'interconnexion, une réalisation d'au moins un espace clos tridimensionnel, une réalisation d'au moins un premier élément piézo-électrique dans le ou les espaces clos, et une réalisation d'au moins un objet logé de façon libre dans un espace clos ou dans chaque espace clos.

Selon un mode de mise en oeuvre, on fait supporter le ou chaque premier élément piézo-électrique par une couche inférieure, par exemple un niveau de métallisation, formant une paroi inférieure de l'espace clos correspondant.

Selon un mode de mise en oeuvre, la réalisation du ou de chaque premier élément piézo-électrique comprend
- une formation sur ladite couche inférieure, d'un empilement comportant une couche support par exemple une couche d'un matériau diélectrique, et une couche d'un matériau piézo-électrique,
- une gravure de la couche de matériau piézo-électrique de façon à former un tapis de poutres, et
- une gravure partielle de la couche support de façon à réaliser le tapis de poutres montées en cantilever.

La réalisation du ou de chaque premier élément piézo-électrique peut comprendre en outre une formation d'un réseau de pistes métallisées sur la couche de matériau piézo-électrique. Cette formation peut s'effectuer de préférence avant la gravure de la couche de matériau piézo-électrique, de façon à éviter le dépôt de métal dans les cavités situées sous les poutres montées en cantilever.

Selon un mode de mise en oeuvre, la réalisation du ou des objets comprend
- une formation sur l'élément piézo-électrique d'une couche intermédiaire, par exemple une couche diélectrique,
- une formation d'une couche additionnelle, par exemple d'une couche d'aluminium ou de tout autre matériau relativement lourd comme du tantale, sur ladite couche intermédiaire,
- une gravure de la couche additionnelle de façon à former partiellement le ou les objets, ceux-ci reposant encore sur la couche intermédiaire,
- une formation d'une couche supplémentaire, par exemple une couche de diélectrique, sur ladite couche gravée,
- une formation d'une tranchée latérale entourant le premier élément piézo-électrique, ladite couche intermédiaire, ladite couche gravée et ladite couche supplémentaire,
- un remplissage de la tranchée, par exemple avec du tungstène,
- une formation sur ladite couche supplémentaire et sur la tranchée, d'une couche supérieure, par exemple du nitrure de silicium,
- une gravure de la couche supérieure de façon à former des ouvertures dont la taille est inférieure à la taille des objets,
- une gravure sélective à travers des ouvertures, de la couche intermédiaire et de la couche supplémentaire, ce qui permet de libérer complètement les objets, ceux-ci tombant alors au fond du logement (espace clos).

La réalisation de l'espace clos peut comporter en outre une formation d'une couche finale sur ladite couche supérieure ajourée, par exemple une couche de diélectrique destinée à supporter un autre niveau de métallisation supérieur du circuit intégré.

Le procédé de fabrication peut comporter en outre une réalisation d'au moins un deuxième élément piézo-électrique en regard du premier élément piézo-électrique.

Dans une telle éventualité, la couche supérieure ajourée à travers laquelle on va procéder à la gravure des couches pour libérer complètement les objets, peut être une couche piézo-électrique qui va former le deuxième élément piézo-électrique ; et, la formation de ce deuxième élément piézo-électrique peut comporter alors
- une formation d'une couche auxiliaire, par exemple une couche de nitrure de silicium, sur la couche piézo-électrique ajourée,
- une gravure partielle de la couche auxiliaire de façon à former une cavité au-dessus d'une partie de la couche piézo-électrique et une partie de soutien de la couche piézo-électrique autour de ladite cavité, et
- une formation sur ladite partie de soutien d'une couche finale de recouvrement recouvrant également ladite cavité.

D'autres avantages et caractéristiques de l'invention apparaîtront à l'examen de la description détaillée de modes de mise en oeuvre et de réalisation, nullement limitatifs et des dessins annexés sur lesquels :
- la figure 1 illustre de façon très schématique un mode de réalisation d'un circuit intégré selon l'invention ;
- la figure 2 illustre un exemple de mise en oeuvre d'un procédé selon l'invention ;
- les figures 3 à 18 illustrent schématiquement des exemples d'étape de fabrication d'un circuit intégré selon l'invention ;
- la figure 19 illustre un exemple de schéma électrique de stockage d'énergie produite par un mode de réalisation d'un circuit intégré selon l'invention ;
- la figure 20 illustre schématiquement un exemple de capteur incorporant un exemple de circuit intégré selon l'invention ; et
- la figure 21 illustre un exemple de fonctionnement d'un tel capteur.

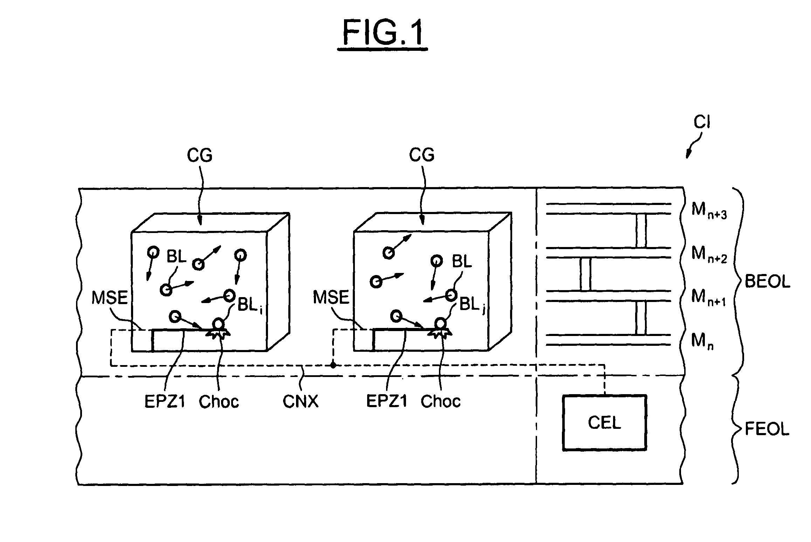

Sur la figure 1, la référence CI désigne un circuit intégré comportant de façon classique et connue en soi une partie FEOL communément désignée par l'homme du métier sous la dénomination anglo-saxonne « front-end-of-line » surmonté d'une deuxième partie BEOL communément désignée par l'homme du métier sous la dénomination anglo-saxonne « back-end-of-line ».

La partie FEOL est en fait la première partie fabriquée du circuit intégré dans laquelle se trouvent les composants actifs individuels tels que par exemple des transistors, des résistances. La partie FEOL englobe généralement tous les différents éléments du circuit intégré jusqu'à la première couche de métal.

La partie supérieure du circuit intégré, à savoir la partie BEOL, est la partie du circuit intégré dans laquelle les composants actifs (transistors, résistances, etc...) sont interconnectés par l'intermédiaire de niveaux de métallisation Mₙ, Mₙ₊₁,... et de vias. Cette partie BEOL commence avec le premier niveau de métallisation et elle inclut également les vias, les couches isolantes ainsi que les plots de contacts disposés sur la partie supérieure du circuit intégré.

Comme illustré sur la figure 1, le circuit intégré CI incorpore, dans la partie BEOL, au moins un espace clos tridimensionnel CG, et en général plusieurs espaces clos tridimensionnels. Sur la figure 1, seuls deux espaces clos tridimensionnels sont représentés à des fins de simplification.

Chaque espace clos tridimensionnel forme en fait une cage ou un logement clos CG incorporant chacun au moins un objet BL, par exemple en forme de bille et plus généralement de patatoïde. Les objets BL, contenus dans chaque cage CG, sont capables de s'y mouvoir librement.

Par ailleurs, chaque logement clos CG est équipé d'au moins d'un élément piézo-électrique EPZ1.

Ainsi, comme on le verra plus en détail ci-après, lors d'une mise en mouvement relatif d'une cage CG et des objets qui y sont contenus, certains au moins de ces objets, peuvent lors de leurs mouvements erratiques venir en contact avec l'élément piézo-électrique EPZ1 comme c'est le cas par exemple pour l'objet BLᵢ ou l'objet BLⱼ. Un tel choc va alors provoquer une déformation de l'élément piézo-électrique et provoquer la délivrance d'une énergie électrique.

Cette énergie électrique est délivrée par l'intermédiaire de moyens de sortie électrique MSE couplés à chaque élément piézo-électrique EPZ1. On reverra plus en détail ci-après sur un exemple de réalisation de ces moyens de sortie électrique MSE. Ces moyens de sortie électrique MSE sont par ailleurs reliés à un circuit spécifique CEL par une connexion électrique CNX.

Comme on le verra plus en détail ci-après, ce circuit spécifique CEL est par exemple capable de stocker l'énergie produite par les chocs successifs des billes sur les éléments piézo-électriques.

Bien que les éléments de ce circuit spécifique CEL pourraient être réalisés entre des niveaux de métallisation, notamment lorsqu'il s'agit de condensateurs, ils sont en pratique réalisés dans la partie FEOL du circuit intégré, mais pas nécessairement sous les cages CG comme illustré par l'exemple sur la figure 1.

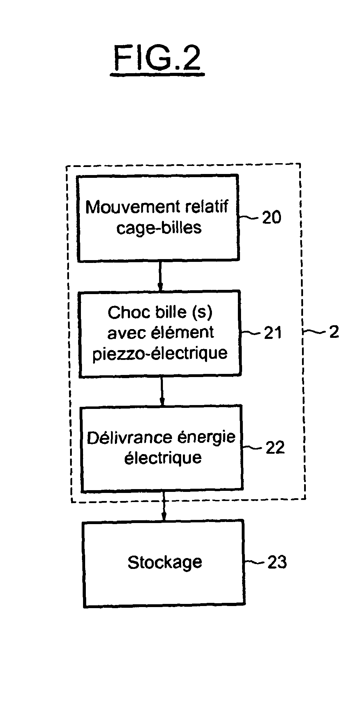

Sur la figure 2, on a illustré de façon schématique les principales étapes d'un procédé de génération d'énergie électrique dans un circuit intégré tel que celui illustré sur la figure 1.

Comme indiqué ci-avant, le mouvement relatif cage-billes 20, (provoqué par exemple par une mise en mouvement du circuit intégré lui-même, ou bien, comme on le verra plus en détail ci-après, par la réception de vibrations) va induire un déplacement erratique des billes dans la cage, provoquant directement ou indirectement par ricochets sur les parois de la cage, un, et en général plusieurs chocs d'une, voire de plusieurs billes avec l'élément piézoélectrique (étape 21).

Chaque choc d'une bille avec l'élément piézoélectrique va provoquer sa déformation et par conséquent la délivrance d'une impulsion d'énergie électrique (étape 22).

Cette énergie électrique peut être utilisée pour recharger par exemple une micro-batterie disposée dans le circuit intégré, ou bien pour alimenter une partie bien spécifique du circuit intégré qui de ce fait n'a plus besoin d'être alimentée par la batterie elle-même du circuit intégré.

L'énergie délivrée peut être également stockée (étape 23) dans le circuit spécifique de stockage CEL afin d'être ultérieurement restituée.

L'utilisation d'objets tridimensionnels, par exemple en forme de billes, et plus généralement de patatoïdes, capables de se déplacer librement dans un espace clos tridimensionnel pour venir entrer en contact avec un élément piézoélectrique, offre une grande souplesse d'utilisation quant à la direction des mouvements de déplacement du circuit intégré. En fait, ce mouvement relatif est capable d'être enclenché quel que soit le type de mouvement et la direction du mouvement auquel est soumis éventuellement le circuit intégré.

De même, cet aspect tridimensionnel du logement en combinaison avec les billes, permet de dé-corréler le fonctionnement du dispositif de production d'énergie d'une quelconque fréquence spécifique de déplacement et/ou de résonance de l'élément piézoélectrique. Le circuit intégré présente par conséquent une large bande passante de fonctionnement.

Bien entendu, la taille des objets ainsi que leur poids devront être adaptés en fonction du volume interne de l'espace clos et des caractéristiques mécaniques de l'élément piézoélectrique, de façon à pouvoir offrir la possibilité d'un mouvement erratique suffisant des objets dans le volume pour obtenir un nombre de chocs suffisant sans risquer de détruire l'élément piézoélectrique.

De même, la taille des objets dans chaque espace clos CG, quoique généralement identique pour des raisons de simplification de fabrication, peut être différente d'un objet à l'autre et/ou d'une cage à une autre.

De même, les éléments piézoélectriques peuvent présenter des configurations géométriques et/ou des formes différentes d'une cage à une autre, voire au sein d'une même cage, lorsqu'une cage comporte plusieurs éléments piézoélectriques.

En pratique, la taille des patatoïdes est micrométrique, voire nanométrique, c'est-à-dire que leurs dimensions sont de l'ordre du micrometre ou inférieures, voire de l'ordre du nanomètre.

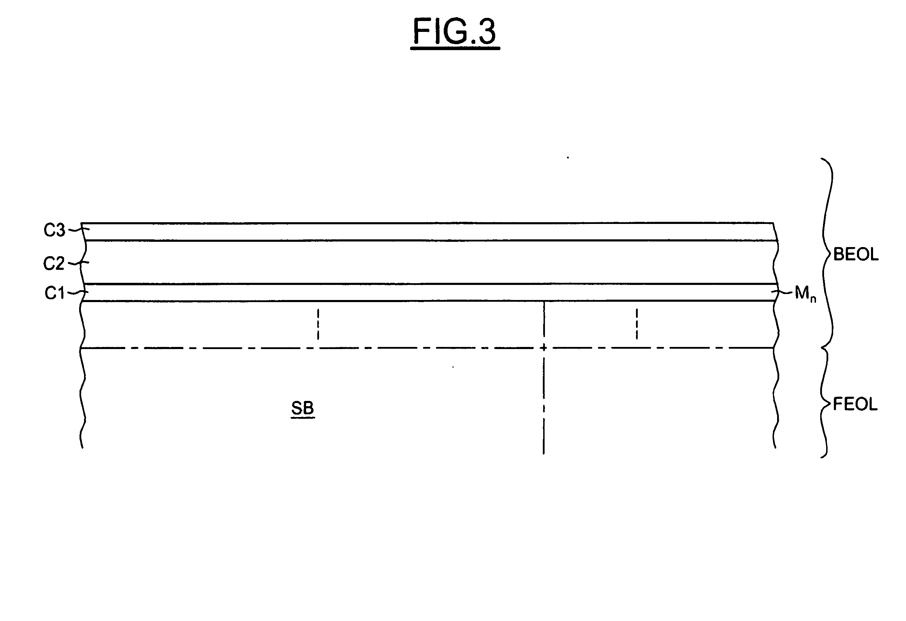

On va maintenant décrire plus en détail et en se référant aux figures 3 à 18, des exemples de réalisation de circuits intégrés selon l'invention.

Sur ces figures, on représentera à des fins de simplification la réalisation d'une seule cage (espace clos) équipée d'éléments piézoélectriques et incorporant des objets, tels que des micro-billes, étant bien entendu que, dans le cas où le circuit intégré incorpore plusieurs cages, celles-ci sont réalisées simultanément.

Sur la figure 3, on suppose que la réalisation de la cage CG, de l'élément piézoélectrique et des objets, débute par le dépôt d'une couche inférieure C1 correspondant ici au niveau de métal/Mₙ. Cette couche C1, par exemple en cuivre ou en aluminium, a par exemple une épaisseur de l'ordre de 400nm (4000 Angströms).

On recouvre ensuite cette couche C1 par une couche C2, formant comme on le verra plus en détail ci-après, une couche support, et composée par exemple d'un matériau diélectrique tel que du dioxyde de silicium ou bien un diélectrique interniveaux. Cette couche C2 est formée de façon classique et connue en soi par exemple par un dépôt chimique en phase vapeur (dépôt CVD) et son épaisseur peut varier par exemple de quelques centaines à quelques milliers d'angströms (1 Å = 0,1nm).

On forme ensuite, par exemple par dépôt, sur la couche support C2, une couche C3 formée d'un matériau piézoélectrique. L'épaisseur de cette couche peut varier la encore de quelques centaines à quelques milliers d'angstrôms selon la technologie utilisée.

De nombreux matériaux piézoélectriques peuvent être utilisés comme par exemple du quartz, du tantale, du nitrure de tantale, ou bien un matériau de la famille des PZT (Titano-Zirconate de Plomb) de formule chimique Pb(Zrₓ, Ti₁₋ₓ)O₃. On utilisera par exemple un dépôt en phase liquide pour un matériau du type PZT ou bien un dépôt classique connu en soi de type CVD pour du tantale ou du nitrure de tantale.

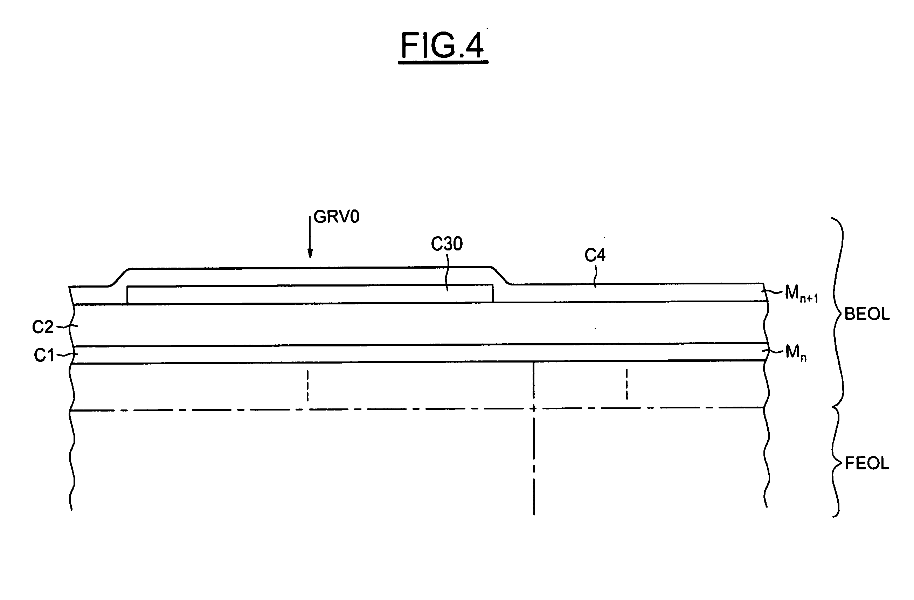

Après avoir gravé par une gravure anisotrope classique et connue en soi GRV0 la couche piézoélectrique C3 (figure 4), de façon à obtenir une portion de couche piézoélectrique C30 dans laquelle vont être réalisés les différents éléments piézoélectriques, on recouvre l'ensemble par une couche électriquement conductrice C4, par exemple par la couche métallique du niveau de métallisation suivant Mₙ₊₁.

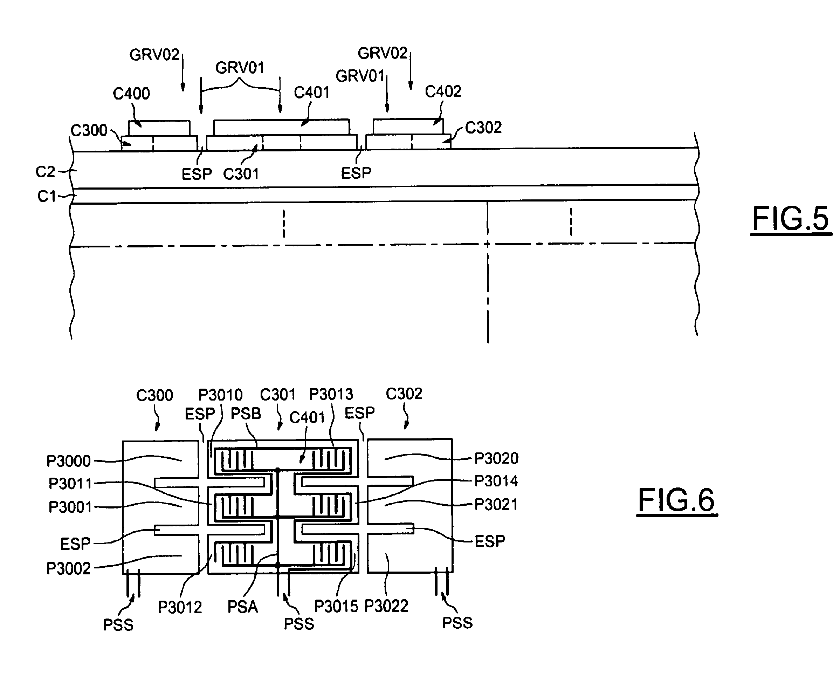

Cette couche métallique C4 va permettre la réalisation, comme on va le voir plus en détail maintenant sur les figures 5 et 6, de pistes métalliques entrelacées permettant de conduire l'énergie électrique résultant de la déformation du matériau piézoélectrique lors des chocs avec les objets.

On voit sur la figure 5 et sur la figure 6, qui est une vue de dessus de la figure 5, que le motif final recherché pour la couche C30 est formé de trois ensemble monoblocs C300, C301 et C302 formant chacun plusieurs poutres. Ainsi, l'ensemble C300 comporte trois poutres P3000, P3001 et P3002 espacées par des espaces ESP.

L'ensemble C301 comporte deux groupes symétriques de trois poutres P3010, P3011, P3012 et P3013, P3014 et P3015.

Les poutres de chaque groupe sont également espacées par des espaces ESP.

L'ensemble C302 comporte également un groupe de trois poutres P3020, P3021 et P3022 également mutuellement espacées d'espaces ESP.

Par ailleurs, les ensembles C300, C301 et C302 sont eux-mêmes mutuellement espacés avec un espace ESP.

Sur cette figure, les espaces ont été référencés par la même référence ESP. Ils peuvent être en pratique égaux ou bien différents.

On réalise par masquage puis par gravure GRV01 de la couche métallique C4, deux pistes métalliques PSA et PSB s'étendant sur l'ensemble des poutres. Plus particulièrement, comme on le voit sur l'ensemble C301, ces deux pistes métalliques forment sur la surface supérieure de chacune des poutres deux peignes dont les dents s'imbriquent. Par ailleurs, la partie de ces deux pistes PSA et PSB qui quitte chaque ensemble C300, C301, C302, est référencée PSS et forme ici un exemple de réalisation des moyens de sortie électriques MSE (figure 1) permettant d'évacuer l'énergie électrique générée par l'élément piézoélectrique.

Ces deux pistes métalliques PSS vont se prolonger par des pistes du niveau de métallisation Mₙ₊₁ pour rejoindre par un autre endroit du circuit intégré, par l'intermédiaire de vias et éventuellement d'autres niveaux de métallisation, le circuit spécifique CEL disposé dans la partie FEOL du circuit intégré. Ces autres pistes et vias éventuels forment un exemple de réalisation de la connexion électrique CNX (figure 1) entre les moyens de sortie PSS et le circuit spécifique CEL.

A des fins de simplification, on n'a pas représenté le serpentin des pistes métalliques PSA et PSB sur les ensembles C300 et C302, mais on a simplement représenté leur sortie PSS.

Une fois que ces pistes métalliques ont été gravées, on procède après masquage à une gravure classique et connue en soi GRV02 de la couche C30 de façon à former les ensembles C300, C301 et C302.

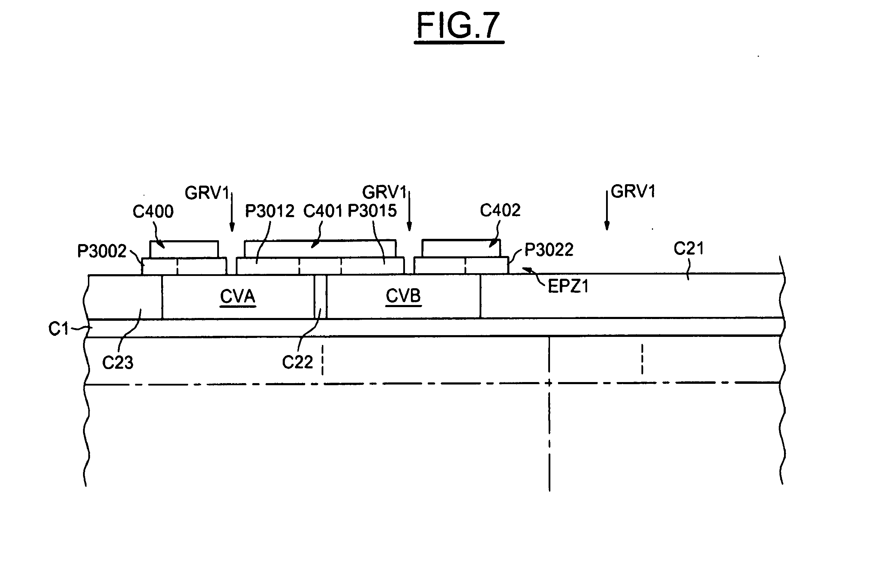

Puis, comme illustré sur la figure 7, on procède à une autre gravure GRV1 de la couche C2 au travers des espaces ESP de façon à créer sous les ensembles C300, C301 et C302 des cavités CVA et CVB. La gravure GRV1 est tout d'abord anisotrope puis isotrope de façon à créer lesdites cavités.

A l'issue de cette opération de gravure, les différentes poutres des différents ensembles sont montées en cantilevers, c'est-à-dire qu'elles sont en porte-à-faux sur les supports résiduels C23, C22 et C21 de la couche C2.

On a ainsi réalisé dans cet exemple, trois éléments piézoélectriques qui sont désignés globalement par la référence EPZ1.

Le premier élément piézoélectrique est formé des trois poutres en cantilevers P3000, P3001 et P3002. Le deuxième élément piézoélectrique est formé des deux groupes symétriques des poutres en cantilevers P3010, P3011, P3012 et P3013, P3014 et P3015.

Le troisième élément piézoélectrique est formé des trois poutres en cantilevers P3020, P3021 et P3022, toutes ces poutres étant recouvertes des métallisations C400, C401 et C402 formant les pistes PSA et PSB.

La gravure des poutres pourrait être effectuée avant la gravure des pistes métalliques. Cela étant il est préférable de faire l'inverse comme décrit ci-avant afin d'éviter le risque d'un dépôt de métal entre les poutres.

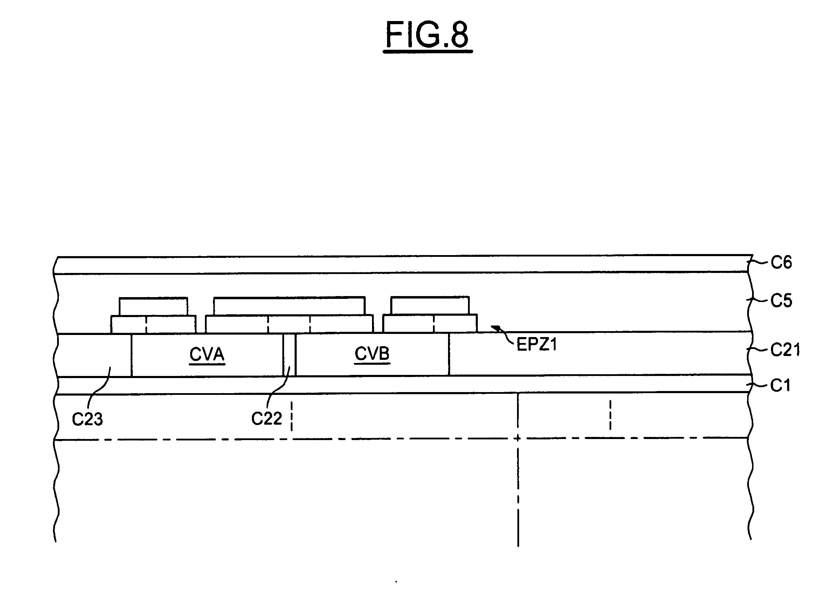

On forme ensuite sur les éléments piézoélectriques EPZ1 et sur les reliquats de couche C21 et C23, une couche intermédiaire C5, par exemple de même composition que celle de la couche C2 et par conséquent de celle des reliquats C21 et C23 (figure 8).

Puis, on forme, par exemple par dépôt, sur la couche intermédiaire, une couche additionnelle C6 dans laquelle on va réaliser les objets destinés à se mouvoir librement dans la cage.

Cette couche C6 peut être formée par exemple d'aluminium, de tantale, de nitrure de silicium, ou bien encore d'un matériau de la famille PZT ou de tout autre matériau suffisamment lourd. L'épaisseur de cette couche C56 va déterminer l'une des dimensions de chaque objet. Cette dimension varie selon la technologie utilisée. Elle peut à titre indicatif être comprise entre quelques centaines d'angströms et un micromètre environ.

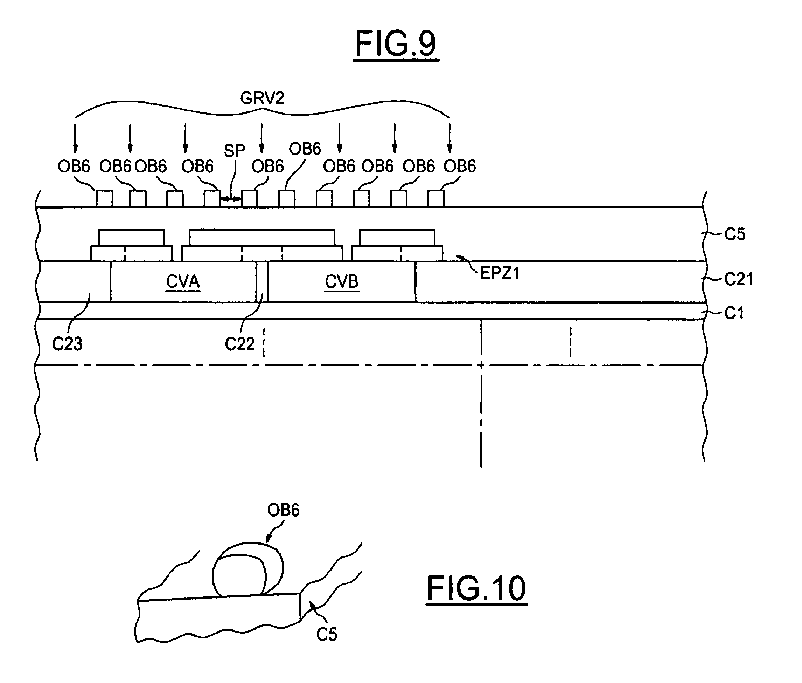

Après avoir masqué la couche C6 de façon à délimiter les objets, on procède (figure 9) à la gravure GRV2 de cette couche C6 de façon à obtenir une multitude d'objets OB6.

Bien que la face avant de chaque objet ait été représenté à des fins de simplification sous la forme d'un carré sur la figure 9, la forme réelle d'un objet est plus une forme de patatoïde résultant des opérations de gravure, comme illustré sur la figure 10.

A ce stade, chaque objet OB6 repose sur la surface supérieure de la couche C5. L'espace SP entre chaque objet est pris par exemple égal à la taille de chaque objet, c'est-à-dire de l'ordre du micromètre par exemple.

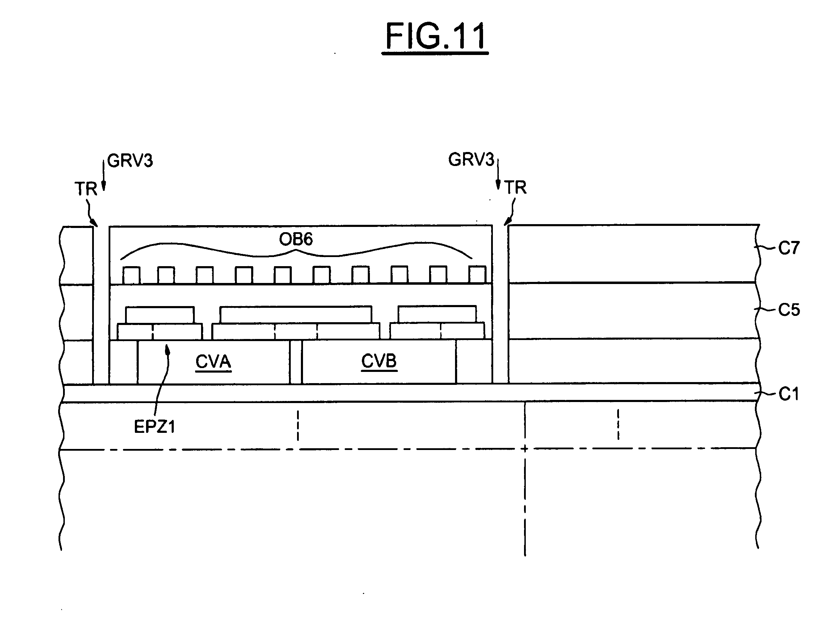

A l'étape suivante (figure 11), on recouvre les objets OB6 et la couche C5 d'une couche supplémentaire C7, par exemple également de même composition que la couche C5. Puis, on procède à une gravure de l'ensemble de part et d'autre des éléments piézoélectriques EPZ1 de façon à définir une tranchée latérale TR. Cette gravure GRV3 est une gravure anisotrope classique et connue en soi qui va s'arrêter sur la couche inférieure C1.

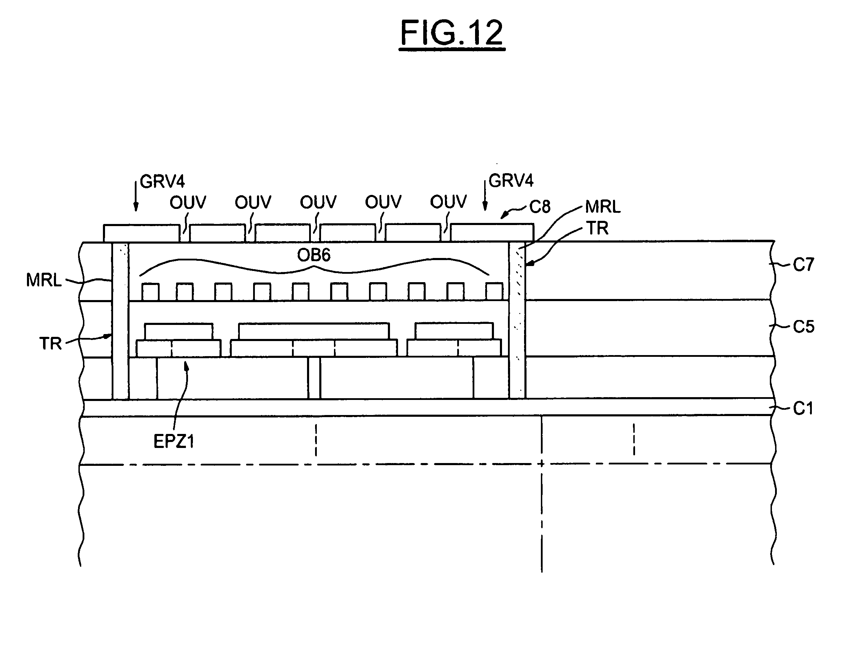

Puis, comme illustré sur la figure 12, on procède au remplissage de cette tranche latérale TR avec un matériau de remplissage MRL, par exemple du tungstène.

On voit donc ici que la cage CG qui sera formée ultérieurement, est délimitée dans sa partie inférieure par la couche inférieure C1 et sur ses côtés par la tranchée latérale TR.

Il convient de noter ici que la tranchée TR peut-être en un ou plusieurs morceaux en fonction des besoins des sorties des signaux et/ou des tailles des cages.

Après une étape de planarisation classique, on forme, par exemple par un dépôt de type CVD classique, une couche supérieure C8 sur la couche C7 et sur les tranchées remplies TR.

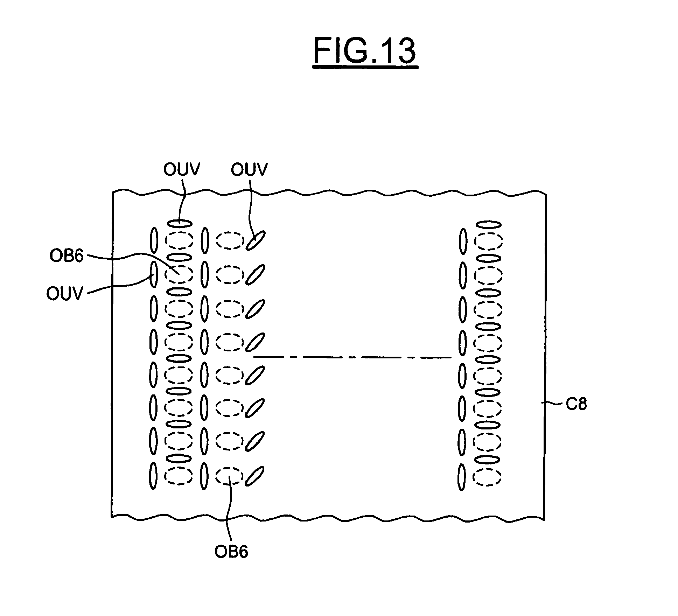

Puis, comme illustré sur la figure 12 et sur la figure 13 qui représente une vue de dessus de la figure 12, on procède à une gravure anisotrope classique connue en soi GRV4 de la couche C8 de façon d'une part, à la délimiter, et d'autre part, à ménager dans cette couche C8 des ouvertures OUV.

Les ouvertures OUV sont préférentiellement disposées à la verticale du pourtour de chaque objet OB6.

L'épaisseur de la couche C8 est de l'ordre de quelques milliers d'angströms par exemple.

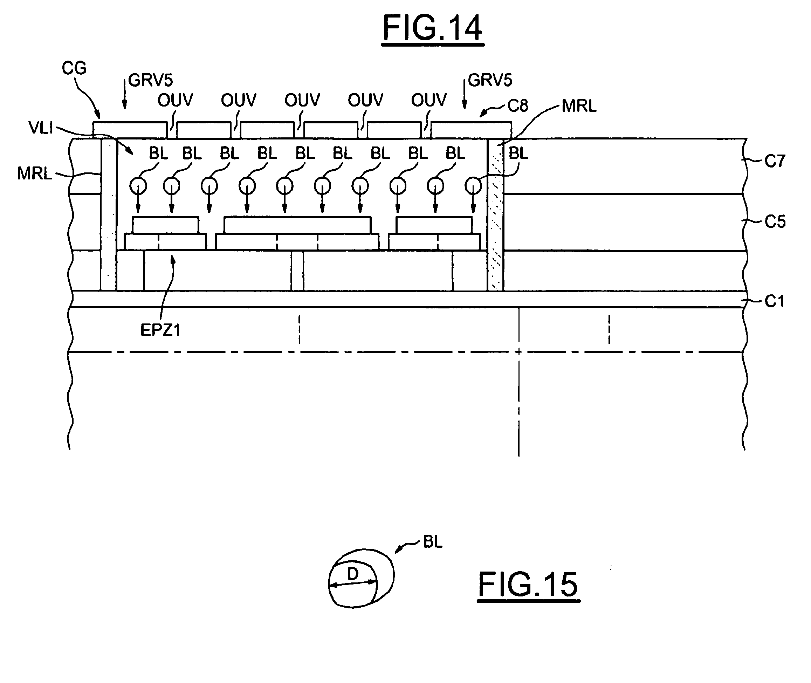

Puis, comme illustré sur la figure 14, on procède à travers les ouvertures OUV à une gravure plasma GRV5 de façon à éliminer le reliquat des couches C7 et C5 entourant les objets OB6.

Par cette gravure, on forme donc les objets finaux en forme de patatoïdes BL qui sont totalement libres, et qui par conséquent à ce stade du procédé, tombent dans le bas de la cage CG sur les éléments piézoélectriques EPZ1.

Mais, bien entendu, dès l'apparition d'un mouvement relatif entre la cage et les objets BL, ceux-ci pourront se mouvoir librement dans le volume libre intérieur VLI de la cage CG qui est délimitée dans sa partie supérieure par la plaque ajourée C8.

A cet égard, la taille des ouvertures OUV, ainsi que la taille des espaces ESP entre les éléments piézoélectriques, est choisie de façon à ce que les objets ne puissent pas d'une part, s'échapper de la cage CG par la partie supérieure, ni tomber dans les cavités ménagées sous les poutres en cantilevers.

A titre indicatif, si D désigne le diamètre d'une sphère BL, ou plus exactement d'un patatoïde, la taille des ouvertures ainsi que la taille des espaces sera de préférence inférieure à D/2.

Ainsi, pour une technologie 90 nanomètres, si l'on choisit une taille D de billes BL de l'ordre de 0,6 micromètre, on prendra des ouvertures OUV et des espaces ESP d'une taille allant de 0,2 à 0,3 micromètre.

Par ailleurs, si les billes BL sont formées d'un matériau électriquement conducteur, comme du tantale par exemple, il est alors prévu de recouvrir les pistes métalliques circulant sur les éléments piézo-électriques d'un matériau isolant, par exemple un nitrure de silicium ou bien un bi-couches nitrure de silicium-oxyde de silicium. Cette opération s'effectuera par exemple avant gravure des pistes. Si par contre les billes BL sont formées d'un matériau électriquement isolant, comme par exemple du nitrure de silicium, il n'est pas nécessaire d'isoler électriquement les pistes métalliques disposées sur les éléments piézo-électriques.

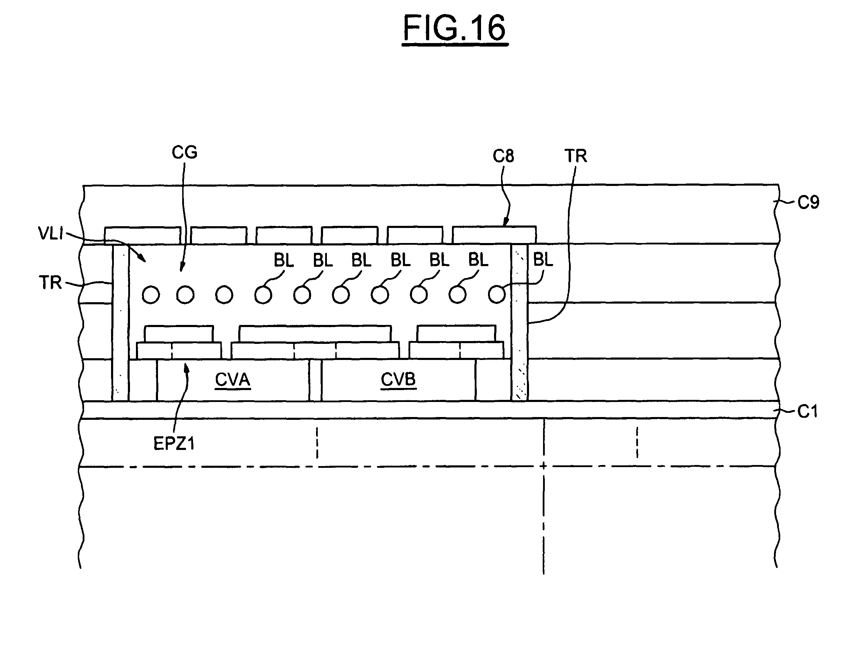

Comme illustré sur la figure 16, on peut éventuellement recouvrir la couche ajourée C8 par une couche finale C9, par exemple en oxyde de silicium.

Il convient de noter ici que les opérations de gravure et de dépôt se font sous très faible pression, ce qui permet de maintenir dans la cage CG, une très faible pression, ce qui favorise le mouvement des objets BL à l'intérieur de la cage. Cela étant, le dispositif fonctionnerait même si de l'air à la pression atmosphérique était contenu dans la cage.

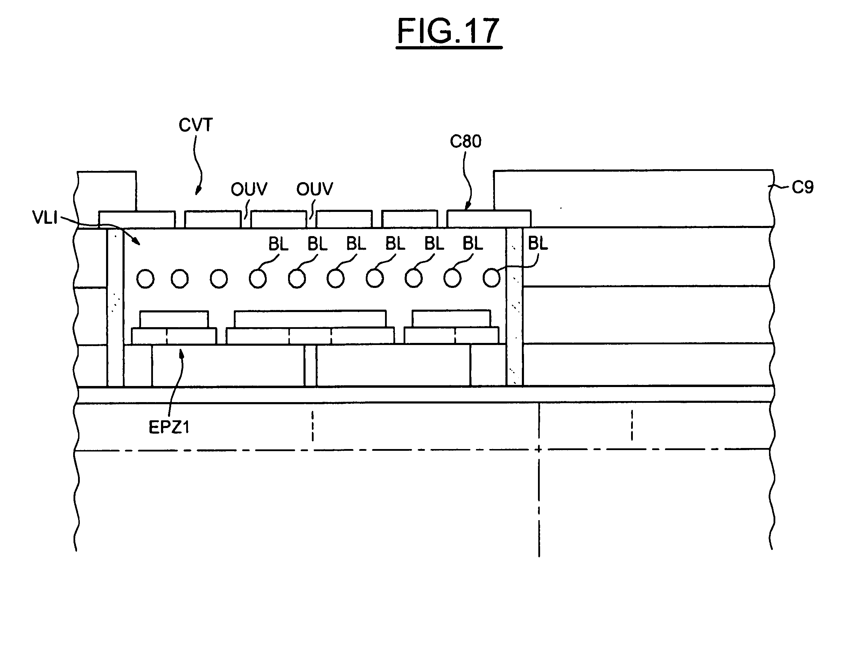

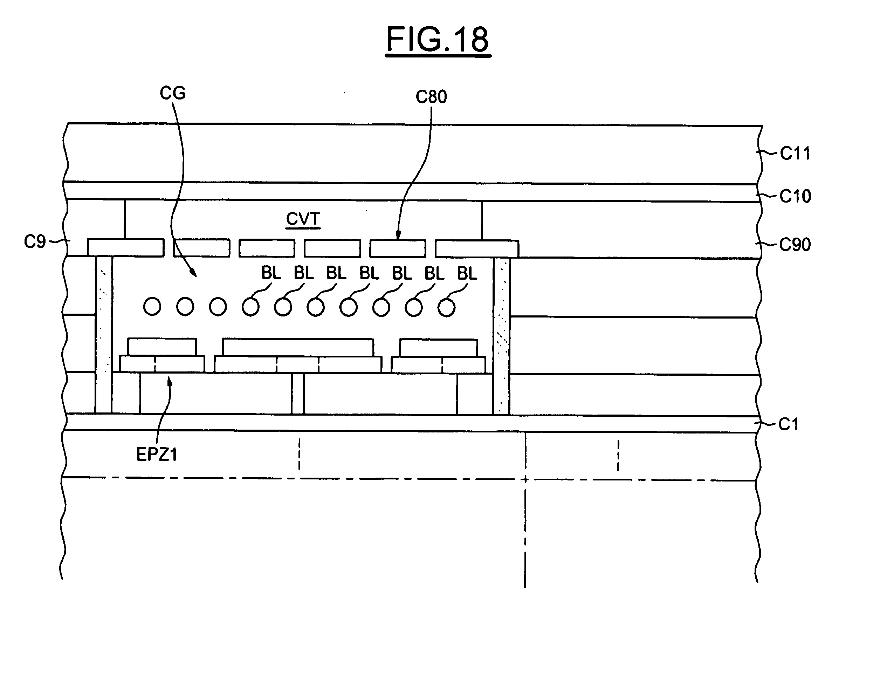

Il est également possible en variante, d'équiper la cage d'un autre élément piézoélectrique au niveau de sa paroi supérieure. Ceci va maintenant être décrit en référence aux figures 17 et 18.

En fait, cette variante est aisément réalisable en remplaçant la couche ajourée de nitrure de silicium C8 de la figure 14 par une couche d'un matériau piézoélectrique, par exemple le même matériau que celui utilisé pour les éléments EPZ1, surmontée de pistes métalliques gravées (non représentées ici à des fins de simplification). On procède alors de la même façon à la gravure des couches disposées à l'intérieur de la cage au travers des ouvertures de la couche piézoélectrique ajourée C80 (figure 17).

Puis, on dépose sur la couche piézoélectrique ajourée C80 une couche auxiliaire C90, par exemple en nitrure de silicium. Après masquage, on grave partiellement cette couche C90 de façon à former une cavité CVT au dessus de la partie centrale de la couche piézoélectrique ajourée C80.

Après cette opération de gravure, la couche piézoélectrique C80 est maintenue sur ses bords par le reliquat de couche C90 et forme donc une couche flexible pouvant fléchir dans une direction orthogonale à son plan, ce qui va se passer lors de chocs avec les billes BL.

La couche C90, ainsi que la cavité CVT sont ensuite recouvertes par une couche finale de recouvrement C10, qui peut être par exemple à un autre niveau de métallisation du circuit intégré (figure 17).

Cette couche C10 peut être également recouverte par la suite d'une autre couche de diélectrique C11.

A partir de la configuration illustrée sur la figure 16 ou de celle illustrée sur la figure 18, la fin de la fabrication du circuit intégré se poursuit normalement de façon classique par la réalisation éventuelle d'autres niveaux de métallisation et la formation de plots de contact sur la surface supérieure du circuit intégré.

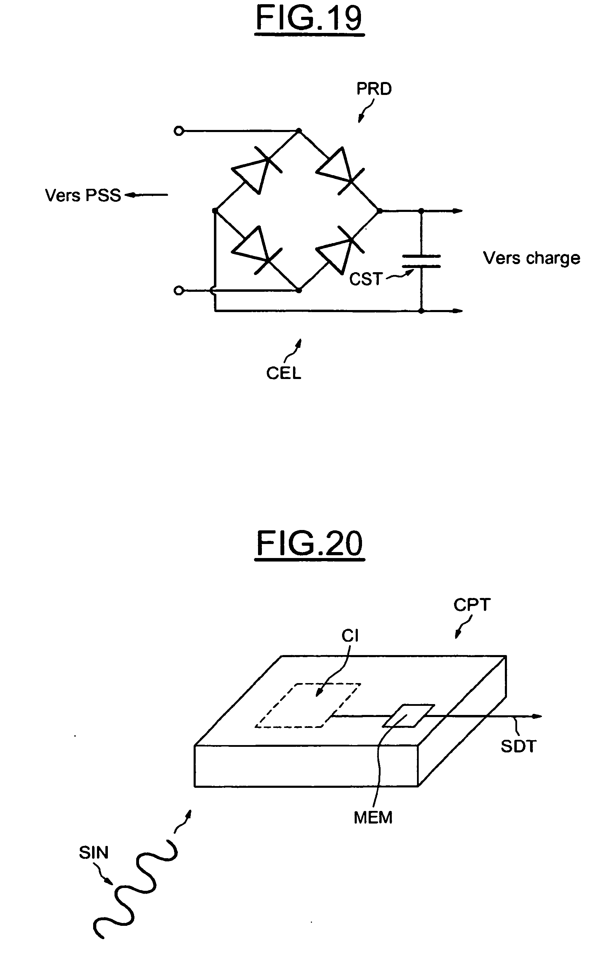

La figure 19 illustre de façon schématique un schéma électrique d'un circuit CEL permettant ici de stocker l'énergie produite au cours de chaque choc d'un objet sur un élément piézoélectrique.

Plus précisément, dans l'exemple décrit ici, qui n'est nullement limitatif, le circuit CEL comporte un pont redresseur PRD à diodes dont les deux entrées sont couplées aux moyens de sortie PSS des différents éléments piézoélectriques.

La sortie du pont redresseur est connectée aux deux bornes d'un condensateur de stockage CST qui va pouvoir éventuellement restituer l'énergie stockée vers une charge du circuit intégré.

Il est possible de prévoir un seul CEL connecté à l'ensemble à l'ensemble des éléments piézo-électriques ou bien plusieurs circuits CEL, tous respectivement connectés à un ou à plusieurs éléments piézo-électriques.

La figure 20 illustre à titre d'exemple non limitatif, une application particulière de l'invention consistant à incorporer le circuit intégré CI dans un capteur CPT. Ce capteur peut être placé sur un support destiné à être en mouvement ou bien recevoir un signal, tel qu'une vibration, SIN émis à distance lors de l'occurrence d'un événement, par exemple la fracture d'une vitre sur laquelle serait placé le capteur CPT.

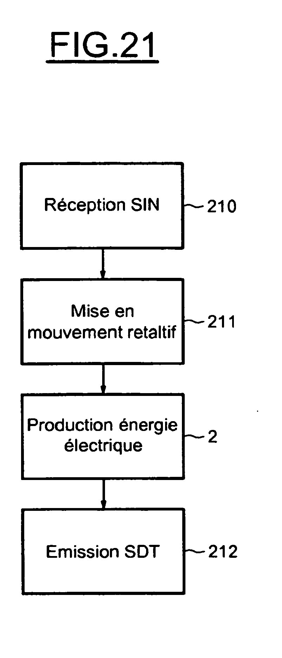

En réponse au mouvement du support sur lequel est éventuellement placé le capteur CPT, ou à la réception du signal vibratoire SIN (étape 210, figure 21) il y a une mise en mouvement relatif des cages et des billes (étape 211), ce qui a pour conséquence la production d'énergie électrique 2 décrite sur la figure 2.

Cette énergie électrique peut être utilisée pour générer l'émission d'un signal de détection SDT (étape 212) par exemple un signal infrarouge ou un signal radiofréquence, au moyen d'un circuit d'émission MEM classique.

## Revendications

1. Procédé de génération d'énergie électrique dans un circuit intégré, comprenant une mise en mouvement relatif (20) d'au moins un espace clos tridimensionnel (CG) ménagé au sein dudit circuit intégré (CI) et contenant au moins un élément piézo-électrique (EPZ1) et d'au moins un objet (BL) logé de façon libre à l'intérieur du ou de chaque espace clos tridimensionnel (CG), et une production d'énergie électrique (22) résultant d'au moins un choc entre l'objet ou l'un au moins des objets et l'élément piézo-électrique ou l'un au moins des éléments piézo-électriques lors dudit mouvement relatif (20).

2. Procédé selon la revendication 1, dans lequel plusieurs objets (BL) sont logés de façon libre dans l'espace clos (CG) ou au moins l'un des espaces clos (CG) et la production d'énergie électrique (22) résulte de chaque choc d'au moins un objet (BL) sur au moins un élément piézo-électrique (EPZ1) à l'intérieur de l'espace clos ou de l'un au moins des espaces clos.

3. Procédé selon la revendication 1 ou 2, dans lequel au moins un espace clos (CG) contient plusieurs éléments piézo-électriques (EPZ1, C80) et la production d'énergie électrique (22) résulte de chaque choc d'au moins un objet sur au moins un élément piézo-électrique à l'intérieur de l'espace clos ou de l'un au moins des espaces clos.

4. Procédé selon l'une des revendications précédentes, dans lequel on fixe au moins un élément piézo-électrique (EPZ1) au voisinage d'au moins une partie d'une paroi de l'espace clos ou de l'un au moins des espaces clos de façon à ce que le ou les objets soient logés de façon libre entre le ou les éléments piézo-électriques et les autres parois de l'espace clos.

5. Procédé selon l'une des revendications précédentes, dans lequel on fixe au moins un premier élément piézo-électrique (EPZ1) au voisinage d'au moins une partie d'une première paroi de l'espace clos ou de l'un au moins des espaces clos et on fixe au moins un deuxième élément piézo-électrique (C80) au voisinage d'au moins une partie d'une deuxième paroi de l'espace clos de façon à ce que le ou les objets soient logés de façon libre entre le ou les premiers éléments piézo-électriques, le ou les deuxièmes éléments piézo-électriques et les autres parois de l'espace clos.

6. Procédé selon l'une des revendications précédentes, dans lequel on loge de façon libre dans l'espace clos ou dans l'un au moins des espaces clos des objets (BL) de tailles identiques ou différentes.

7. Procédé selon l'une des revendications précédentes, dans lequel on ménage le ou les espaces clos au dessus d'un niveau de métallisation (Mₙ) du circuit intégré.

8. Procédé selon l'une des revendications précédentes, dans lequel on stocke (23) l'énergie produite dans un moyen de stockage (CST) ménagé dans le circuit intégré.

9. Procédé selon l'une des revendications précédentes, dans lequel ladite mise en mouvement relatif résulte de l'occurrence d'un évènement externe au circuit intégré interagissant directement ou à distance (SIN) avec ledit circuit intégré (CI).

10. Procédé de détection de l'occurrence d'un évènement externe au circuit intégré, comprenant un procédé de génération d'énergie dans le circuit intégré selon l'une des revendications 1 à 9, ladite mise en mouvement relatif (211) étant provoquée par une action résultant de ladite occurrence, et l'émission (212) d'un signal (SDT) généré à partir de ladite production d'énergie.

11. Circuit intégré, comprenant au moins un espace clos tridimensionnel (CG) ménagé au sein dudit circuit intégré (CI) et contenant au moins un élément piézo-électrique (EPZ1), au moins un objet (BL) logé de façon libre dans l'espace clos ou chaque espace clos tridimensionnel, et des moyens de sortie électriquement conducteurs (MSE), couplés au ou aux éléments piézo-électriques, et configurés pour délivrer une énergie électrique résultant d'au moins un choc entre l'objet ou l'un au moins des objets et l'élément piézo-électrique ou l'un au moins des éléments piézo-électriques lors d'un mouvement relatif du ou des objets et de l'espace clos ou des espace clos correspondants.

12. Circuit intégré selon la revendication 11, dans lequel plusieurs objets (BL) sont logés de façon libre dans l'espace clos ou dans l'un au moins des espaces clos.

13. Circuit intégré selon la revendication 11 ou 12, dans lequel l'espace clos ou l'un au moins des espaces clos contient plusieurs éléments piézo-électriques (EPZ1, C80).

14. Circuit intégré selon l'une des revendications 11 à 13, dans lequel au moins un élément piézo-électrique (EPZ1) est fixé au voisinage d'au moins une partie d'une première paroi de l'espace clos ou de l'un au moins des espaces clos de façon à ce que le ou les objets (BL) soient logés de façon libre entre le ou les éléments piézo-électriques et les autres parois de l'espace clos.

15. Circuit intégré selon l'une des revendications 11 à 14, dans lequel au moins un premier élément piézo-électrique (EPZ1) est fixé au voisinage d'au moins une partie d'une première paroi (C1) de l'espace clos ou de l'un au moins des espaces clos et au moins un deuxième élément (C80) piézo-électrique est fixé au voisinage d'au moins une partie d'une deuxième paroi dudit espace clos de façon à ce que le ou les objets (BL) soient logés de façon libre entre le ou les premiers éléments piézo-électriques, le ou les deuxièmes éléments piézo-électriques et les autres parois dudit espace clos.

16. Circuit intégré selon l'une des revendications 11 à 15, dans lequel au moins un élément piézo-électrique (EPZ1) comporte au moins une poutre (P3002) montée en cantilever et formée d'au moins un matériau piézo-électrique.

17. Circuit intégré selon l'une des revendications 11 à 16, dans lequel au moins un élément piézo-électrique (EPZ1) comporte un ensemble monobloc (C300, C301, C302) comportant plusieurs poutres, chaque poutre étant montée en cantilever et formée d'au moins un matériau piézo-électrique.

18. Circuit intégré selon la revendication 16 ou 17 prise en combinaison avec la revendication 14, dans lequel la ou les poutres montées en cantilever sont montées à distance de ladite première paroi (C1) de façon à former un tapis piézo-électrique ajouré (P3000-P3001 ; P3010-P3015 ; P3020-P3022) disposé en regard de ladite première paroi (C1), les espaces ajourés (ESP) du tapis ayant une taille inférieure à la taille de chaque objet.

19. Circuit intégré selon l'une des revendications 11 à 15, dans lequel au moins un élément piézo-électrique comporte une plaque ajourée (C80) fixée par ses bords dans au moins un espace clos de façon à pouvoir se déformer dans une direction orthogonale à sa surface, ladite plaque étant formée d'au moins un matériau piézo-électrique, les espaces ajourés de la plaque ayant une taille inférieure à la taille de chaque objet.

20. Circuit intégré selon les revendications 15, 18, et 19, dans lequel le tapis de poutres et ladite plaque ajourées (C80) sont disposées en regard l'une de l'autre, le ou les objets (BL) étant logés de façon libre entre le tapis et la plaque.

21. Circuit intégré selon l'une des revendications 11 à 20, dans lequel les objets (BL) logés dans l'espace clos (CG) ou dans l'un au moins des espaces clos (CG) ont des tailles identiques ou différentes.

22. Circuit intégré selon la revendication 21, dans lequel la taille (D) de chaque objet est une taille au plus micrométrique.

23. Circuit intégré selon l'une des revendications 11 à 22, dans lequel chaque objet (BL) est en forme de patatoïde.

24. Circuit intégré selon l'une des revendications 11 à 23, dans lequel le ou les espaces clos est disposé au dessus d'un niveau de métallisation (Mₙ) du circuit intégré.

25. Circuit intégré selon l'une des revendications 11 à 24, comprenant en outre un moyen de stockage (CST), couplé aux moyens de sortie électriques et configuré pour stocker l'énergie produite.

26. Dispositif de détection de l'occurrence d'un évènement, comprenant un circuit intégré (CI) selon l'une des revendications 11 à 25 agencé pour recevoir un signal incident (SIN) résultant de ladite occurrence et capable de provoquer ladite mise en mouvement relatif, et des moyens d'émission (MEM) configurés pour délivrer un signal de sortie généré à partir de l'énergie délivrée par les moyens de sortie du circuit intégré.

27. Procédé de fabrication d'un circuit intégré, **caractérisé en qu'**il comprend une réalisation d'au moins un espace clos tridimensionnel (CG), une réalisation d'au moins un premier élément piézo-électrique (EPZ1) dans le ou les espaces clos, et une réalisation d'au moins un objet (BL) logé de façon libre dans l'espace clos ou dans chaque espace clos.

28. Procédé selon la revendication 27, comprenant une réalisation d'une partie active (FEOL) du circuit intégré et une réalisation d'une partie d'interconnexion (BEOL) au dessus de la partie active, et ladite réalisation dudit au moins un espace clos tridimensionnel (CG), ladite réalisation dudit au moins un premier élément piézo-électrique (EPZ1) dans le ou les espaces clos, et ladite réalisation dudit au moins un objet (BL) logé de façon libre dans l'espace clos ou dans chaque espace clos sont effectuées lors de la réalisation de ladite partie d'interconnexion (BEOL).

29. Procédé selon la revendication 28, dans lequel on fait supporter le ou chaque premier élément piézo-électrique par une couche inférieure (C1) formant une paroi inférieure de l'espace clos correspondant.

30. Procédé selon la revendication 29, dans lequel la réalisation du ou de chaque premier élément piézo-électrique comprend une formation sur ladite couche inférieure, d'un empilement comportant une couche support (C2) et une couche (C3) d'un matériau piézo-électrique, une gravure de la couche de matériau piézo-électrique de façon à former un tapis de poutres, et une gravure partielle de la couche support de façon à réaliser le tapis de poutres montées en cantilever.

31. Procédé selon la revendication 30, dans lequel la réalisation du ou de chaque premier élément piézo-électrique (EPZ1) comprend en outre une formation d'un réseau de pistes métallisées (PSA, PSB) sur la couche de matériau piézo-électrique.

32. Procédé selon l'une des revendications 28 à 31, dans lequel la réalisation du ou des objets comprend
- une formation sur l'élément piézo-électrique d'une couche intermédiaire (C5),
- une formation d'une couche additionnelle (C6) sur ladite couche intermédiaire (C5),
- une gravure (GRV2) de la couche additionnelle (C6) de façon à former partiellement le ou les objets,
- une formation d'une couche supplémentaire (C7) sur ladite couche gravée,
- une formation d'une tranchée latérale (TR) entourant le premier élément piézo-électrique (EPZ1), ladite couche intermédiaire (C5), ladite couche gravée (OB6) et la couche supplémentaire (C7),
- un remplissage de la tranchée (TR),
- une formation sur ladite couche supplémentaire (C7) et sur la tranchée (TR), d'une couche supérieure (C8),
- une gravure (GVR4) de la couche supérieure (C8) de façon à former une couche ajourée ayant des ouvertures (OUV) dont la taille est inférieure à la taille des objets, et
- une gravure sélective (GVR5), à travers les ouvertures (OUV), de la couche intermédiaire (C5) et de la couche supplémentaire (C7).

33. Procédé selon la revendication 32, dans lequel la réalisation de l'espace clos comporte en outre une formation d'une couche finale (C9) sur ladite couche supérieure ajourée.

34. Procédé selon l'une des revendications 28 à 33, comprenant en outre une réalisation d'au moins un deuxième élément piézo-électrique (C80) en regard du premier élément piézo-électrique.

35. Procédé selon les revendications 32 et 34, dans lequel ladite couche supérieure ajourée est une couche piézo-électrique (C80) formant le deuxième élément piézo-électrique, et la formation de ce deuxième élément piézo-électrique comporte une formation d'une couche auxiliaire (C90) sur la couche piézo-électrique, une gravure partielle de la couche auxiliaire (C90) de façon à former une cavité (CVT) au-dessus d'une partie de la couche piézo-électrique et une partie de soutien de ladite couche piézo-électrique autour de la cavité, et une formation sur ladite partie de soutien d'une couche finale de recouvrement (C10) recouvrant ladite cavité (CVT).

## Claims

1. Method of generating electrical energy in an integrated circuit, comprising a setting into relative motion (20) of at least one three-dimensional enclosed space (CG) made within the said integrated circuit (CI) and containing at least one piezo-electric element (EPZ1) and of at least one object (BL) housed in a free manner inside the or each three-dimensional enclosed space (CG), and a production of electrical energy (22) resulting from at least one impact between the object or at least one of the objects and the piezo-electric element or at least one of the piezo-electric elements during the said relative motion (20).

2. Method according to Claim 1, in which several objects (BL) are housed in a free manner in the enclosed space (CG) or at least one of the enclosed spaces (CG) and the electrical energy production (22) results from each impact of at least one object (BL) on at least one piezo-electric element (EPZ1) inside the enclosed space or at least one of the enclosed spaces.

3. Method according to Claim 1 or 2, in which at least one enclosed space (CG) contains several piezo-electric elements (EPZ1, C80) and the electrical energy production (22) results from each impact of at least one object on at least one piezo-electric element inside the enclosed space or at least one of the enclosed spaces.

4. Method according to one of the preceding claims, in which at least one piezo-electric element (EPZ1) is fixed in the vicinity of at least one part of a wall of the enclosed space or of at least one of the enclosed spaces in such a way that the object or objects is or are housed in a free manner between the piezo-electric element or elements and the other walls of the enclosed space.

5. Method according to one of the preceding claims, in which at least one first piezo-electric element (EPZ1) is fixed in the vicinity of at least one part of a first wall of the enclosed space or of at least one of the enclosed spaces and at least one second piezo-electric element (C80) is fixed in the vicinity of at least one part of a second wall of the enclosed space in such a way that the object or objects is or are housed in a free manner between the first piezo-electric element or elements, the second piezo-electric element or elements and the other walls of the enclosed space.

6. Method according to one of the preceding claims, in which objects (BL) of identical or different sizes are housed in a free manner in the enclosed space or in at least one of the enclosed spaces.

7. Method according to one of the preceding claims, in which the enclosed space or spaces is or are made above a metallization level (Mₙ) of the integrated circuit.

8. Method according to one of the preceding claims, in which the energy produced is stored (23) in a storage means (CST) made in the integrated circuit.

9. Method according to one of the preceding claims, in which the said setting into relative motion results from the occurrence of an event external to the integrated circuit interacting directly or at a distance (SIN) with the said integrated circuit (CI).

10. Method for detecting the occurrence of an event external to the integrated circuit, comprising a method of generating energy in the integrated circuit according to one of Claims 1 to 9, the said setting into relative motion (211) being caused by an action resulting from the said occurrence, and the emission (212) of a signal (SDT) generated on the basis of the said energy production.

11. Integrated circuit, comprising at least one three-dimensional enclosed space (CG) made within the said integrated circuit (CI) and containing at least one piezo-electric element (EPZ1), at least one object (BL) housed in a free manner in the three-dimensional enclosed space or each enclosed space, and electrically conducting output means (MSE), coupled to the piezo-electric element or elements, and configured to deliver electrical energy resulting from at least one impact between the object or at least one of the objects and the piezo-electric element or at least one of the piezo-electric elements during a relative motion of the object or objects and of the corresponding enclosed space or enclosed spaces.

12. Integrated circuit according to Claim 11, in which several objects (BL) are housed in a free manner in the enclosed space or in at least one of the enclosed spaces.

13. Integrated circuit according to Claim 11 or 12, in which the enclosed space or at least one of the enclosed spaces contains several piezo-electric elements (EPZ1, C80).

14. Integrated circuit according to one of Claims 11 to 13, in which at least one piezo-electric element (EPZ1) is fixed in the vicinity of at least one part of a first wall of the enclosed space or of at least one of the enclosed spaces in such a way that the object or objects (BL) is or are housed in a free manner between the piezo-electric element or elements and the other walls of the enclosed space.

15. Integrated circuit according to one of Claims 11 to 14, in which at least one first piezo-electric element (EPZ1) is fixed in the vicinity of at least one part of a first wall (C1) of the enclosed space or of at least one of the enclosed spaces and at least one second piezo-electric element (C80) is fixed in the vicinity of at least one part of a second wall of the said enclosed space in such a way that the object or objects (BL) is or are housed in a free manner between the first piezo-electric element or elements, the second piezo-electric element or elements and the other walls of the said enclosed space.

16. Integrated circuit according to one of Claims 11 to 15, in which at least one piezo-electric element (EPZ1) comprises at least one beam (P3002) mounted in cantilever fashion and formed of at least one piezo-electric material.

17. Integrated circuit according to one of Claims 11 to 16, in which at least one piezo-electric element (EPZ1) comprises a monoblock assembly (C300, C301, C302) comprising several beams, each beam being mounted in cantilever fashion and formed of at least one piezo-electric material.

18. Integrated circuit according to Claim 16 or 17 taken in combination with Claim 14, in which the beam or beams mounted in cantilever fashion are mounted at a distance from the said first wall (C1) so as to form an apertured piezo-electric mat (P3000-P3001; P3010-P3015; P3020-P3022) disposed facing the said first wall (C1), the apertured spaces (ESP) of the mat having a smaller size than the size of each object.

19. Integrated circuit according to one of Claims 11 to 15, in which at least one piezo-electric element comprises an apertured plate (C80) fixed by its edges in at least one enclosed space so as to be able to deform in a direction orthogonal to its surface, the said plate being formed of at least one piezo-electric material, the apertured spaces of the plate having a smaller size than the size of each object.

20. Integrated circuit according to Claims 15, 18 and 19, in which the apertured mat of beams and the said apertured plate (C80) are disposed facing one another, the object or objects (BL) being housed in a free manner between the mat and the plate.

21. Integrated circuit according to one of Claims 11 to 20, in which the objects (BL) housed in the enclosed space (CG) or in at least one of the enclosed spaces (CG) have identical or different sizes.

22. Integrated circuit according to Claim 21, in which the size (D) of each object is an at most micrometric size.

23. Integrated circuit according to one of Claims 11 to 22, in which each object (BL) is potatoid-shaped.

24. Integrated circuit according to one of Claims 11 to 23, in which the enclosed space or spaces is disposed above a metallization level (Mₙ) of the integrated circuit.

25. Integrated circuit according to one of Claims 11 to 24, furthermore comprising a storage means (CST), coupled to the electrical output means and configured to store the energy produced.

26. Device for detecting the occurrence of an event, comprising an integrated circuit (CI) according to one of Claims 11 to 25 designed to receive an incident signal (SIN) resulting from the said occurrence and capable of causing the said setting into relative motion, and emission means (MEM) configured to deliver an output signal generated on the basis of the energy delivered by the output means of the integrated circuit.

27. Method of fabricating an integrated circuit, **characterized in that** it comprises a making of at least one three-dimensional enclosed space (CG), a making of at least one first piezo-electric element (EPZ1) in the enclosed space or spaces, and a making of at least one object (BL) housed in a free manner in the enclosed space or in each enclosed space.

28. Method according to Claim 27, comprising a making of an active part (FEOL) of the integrated circuit and a making of an interconnection part (BEOL) above the active part, and said making of said at least one three-dimensional enclosed space (CG), said making of said at least one first piezo-electric element (EPZ1) in the enclosed space or spaces, and said making of said at least one object (BL) housed in a free manner in the enclosed space or in each enclosed space are performed during the making of the said interconnection part (BEOL).

29. Method according to Claim 28, in which a lower layer (C1) forming a lower wall of the corresponding enclosed space is made to support the or each first piezo-electric element.

30. Method according to Claim 29, in which the making of the or of each first piezo-electric element comprises a formation on the said lower layer, of a stack comprising a support layer (C2) and a layer (C3) of a piezo-electric material, an etching of the piezo-electric material layer so as to form a mat of beams, and a partial etching of the support layer so as to make the mat of beams mounted in cantilever fashion.

31. Method according to Claim 30, in which the making of the or of each first piezo-electric element (EPZ1) furthermore comprises a formation of a network of metallized tracks (PSA, PSB) on the piezo-electric material layer.

32. Method according to one of Claims 28 to 31, in which the making of the object or objects comprises
- a formation on the piezo-electric element of an intermediate layer (C5),
- a formation of an extra layer (C6) on the said intermediate layer (C5),
- an etching (GRV2) of the extra layer (C6) so as to partially form the object or objects,
- a formation of an additional layer (C7) on the said etched layer,
- a formation of a lateral trench (TR) surrounding the first piezo-electric element (EPZ1), the said intermediate layer (C5), the said etched layer (OB6) and the additional layer (C7),
- a filling of the trench (TR),
- a formation on the said additional layer (C7) and on the trench (TR), of an upper layer (C8),
- an etching (GVR4) of the upper layer (C8) so as to form an apertured layer having openings (OUV) whose size is smaller than the size of the objects, and
- a selective etching (GVR5), through the openings (OUV), of the intermediate layer (C5) and of the additional layer (C7).

33. Method according to Claim 32, in which the making of the enclosed space furthermore comprises a formation of a final layer (C9) on the said apertured upper layer.

34. Method according to one of Claims 28 to 33, furthermore comprising a making of at least one second piezo-electric element (C80) facing the first piezo-electric element.

35. Method according to Claims 32 and 34, in which the said apertured upper layer is a piezo-electric layer (C80) forming the second piezo-electric element, and the formation of this second piezo-electric element comprises a formation of an auxiliary layer (C90) on the piezo-electric layer, a partial etching of the auxiliary layer (C90) so as to form a cavity (CVT) above a part of the piezo-electric layer and a part for bracing the said piezo-electric layer around the cavity, and a formation on the said bracing part of a final covering layer (C10) covering the said cavity (CVT).

## Patentansprüche

1. Verfahren zur Erzeugung elektrischer Energie in einer integrierten Schaltung, das ein Versetzen in Relativbewegung (20) wenigstens eines dreidimensionalen umschlossenen Raums (CG), der innerhalb der integrierten Schaltung (CI) angeordnet ist und wenigstens ein piezoelektrisches Element (EPZ1) enthält und wenigstens eines Objekts (BL), das im Inneren des oder jedes dreidimensionalen umschlossenen Raums (CG) frei gelagert ist, und eine Erzeugung elektrischer Energie (22), die aus wenigstens einem Aufprall zwischen dem Objekt oder wenigstens einem der Objekte und dem piezoelektrischen Element oder wenigstens einem der piezoelektrischen Elemente bei der Relativbewegung (20) resultiert, umfasst.

2. Verfahren nach Anspruch 1, bei dem mehrere Objekte (BL) in dem umschlossenen Raum (CG) oder wenigstens einem der umschlossenen Räume (CG) frei gelagert sind und die Erzeugung elektrischer Energie (22) aus jedem Aufprall wenigstens eines Objekts (BL) auf wenigstens ein piezoelektrisches Element (EPZ1) im Inneren des umschlossenen Raums oder wenigstens eines der umschlossenen Räume resultiert.

3. Verfahren nach Anspruch 1 oder 2, bei dem wenigstens ein umschlossener Raum (CG) mehrere piezoelektrische Elemente (EPZ1, C80) enthält und die Erzeugung elektrischer Energie (22) aus jedem Aufprall wenigstens eines Objekts auf wenigstens ein piezoelektrisches Element im Inneren des umschlossenen Raums oder wenigstens eines der umschlossenen Räume resultiert.

4. Verfahren nach einem der vorhergehenden Ansprüche, bei dem wenigstens ein piezoelektrisches Element (EPZ1) in der Nähe wenigstens eines Abschnitts einer Wand des umschlossenen Raums oder wenigstens eines der umschlossenen Räume befestigt wird, derart, dass das oder die Objekte zwischen dem oder den piezoelektrischen Elementen und den anderen Wänden des umschlossenen Raums frei gelagert sind.

5. Verfahren nach einem der vorhergehenden Ansprüche, bei dem wenigstens ein erstes piezoelektrisches Element (EPZ1) in der Nähe wenigstens eines Abschnitts einer ersten Wand des umschlossenen Raums oder wenigstens eines der umschlossenen Räume befestigt wird und wenigstens ein zweites piezoelektrisches Element (C80) in der Nähe wenigstens eines Abschnitts einer zweiten Wand des umschlossenen Raums befestigt wird, derart, dass das oder die Objekte zwischen dem oder den ersten piezoelektrischen Elementen, dem oder den zweiten piezoelektrischen Elementen und den anderen Wänden des umschlossenen Raums frei gelagert sind.

6. Verfahren nach einem der vorhergehenden Ansprüche, bei dem in dem umschlossenen Raum oder in wenigstens einem der umschlossenen Räume Objekte (BL) gleicher oder unterschiedlicher Größen frei gelagert werden.

7. Verfahren nach einem der vorhergehenden Ansprüche, bei dem der oder die umschlossenen Räume über einer Metallisierungsebene (Mₙ) der integrierten Schaltung angeordnet werden.

8. Verfahren nach einem der vorhergehenden Ansprüche, bei dem die erzeugte Energie in einem Speichermittel (CST), das in der integrierten Schaltung angeordnet ist, gespeichert wird (23).

9. Verfahren nach einem der vorhergehenden Ansprüche, bei dem das Versetzen in Relativbewegung aus dem Eintreten eines für die integrierte Schaltung externen Ereignisses resultiert, das mit der integrierten Schaltung (CI) unmittelbar oder mittelbar (SIN) in Wechselwirkung steht.

10. Verfahren zur Erfassung des Eintretens eines für die integrierte Schaltung externen Ereignisses, das ein Verfahren zur Erzeugung von Energie in der integrierten Schaltung nach einem der Ansprüche 1 bis 9 umfasst, wobei das Versetzen in Relativbewegung (211) durch eine Wirkung hervorgerufen wird, die aus dem Eintreten resultiert, und das Senden (212) eines Signals (SDT), das ausgehend von der Energieerzeugung erzeugt wird.

11. Integrierte Schaltung, die wenigstens einen dreidimensionalen umschlossenen Raum (CG) umfasst, der innerhalb der integrierten Schaltung (CI) angeordnet ist und wenigstens ein piezoelektrisches Element (EPZ1) enthält, die wenigstens ein Objekt (BL), das in dem umschlossenen Raum oder jedem dreidimensionalen umschlossenen Raum frei gelagert ist, und die Mittel zum elektrischen Anschluss von Leitern (MSE), die mit dem oder den piezoelektrischen Elementen gekoppelt und konfiguriert sind, um eine elektrische Energie abzugeben, die aus wenigstens einem Aufprall zwischen dem Objekt oder wenigstens einem der Objekte und dem piezoelektrischen Element oder wenigstens einem der piezoelektrischen Elemente bei einer Relativbewegung des oder der Objekte und des entsprechenden umschlossenen Raums oder der entsprechenden umschlossen Räume resultiert, umfasst.

12. Integrierte Schaltung nach Anspruch 11, wobei mehrere Objekte (BL) in dem umschlossenen Raum oder wenigstens einem der umschlossenen Räume frei gelagert sind.

13. Integrierte Schaltung nach Anspruch 11 oder 12, wobei der umschlossene Raum oder wenigstens einer der umschlossenen Räume mehrere piezoelektrische Elemente (EPZ1, C80) enthält.

14. Integrierte Schaltung nach einem der Ansprüche 11 bis 13, wobei wenigstens ein piezoelektrisches Element (EPZ1) in der Nähe wenigstens eines Abschnitts einer ersten Wand des umschlossenen Raums oder wenigstens eines der umschlossenen Räume befestigt ist, derart, dass das oder die Objekte (BL) zwischen dem oder den piezoelektrischen Elementen und den anderen Wänden des umschlossenen Raums frei gelagert sind.

15. Integrierte Schaltung nach einem der Ansprüche 11 bis 14, wobei wenigstens ein erstes piezoelektrisches Element (EPZ1) in der Nähe wenigstens eines Abschnitts einer ersten Wand (C1) des umschlossenen Raums oder wenigstens eines der umschlossenen Räume befestigt ist und wenigstens ein zweites piezoelektrisches Element (C80) (C80) in der Nähe wenigstens eines Abschnitts einer zweiten Wand des umschlossenen Raums befestigt ist, derart, dass das oder die Objekte (BL) zwischen dem oder den ersten piezoelektrischen Elementen, dem oder den zweiten piezoelektrischen Elementen und den anderen Wänden des umschlossenen Raums frei gelagert sind.

16. Integrierte Schaltung nach einem der Ansprüche 11 bis 15, wobei wenigstens ein piezoelektrisches Element (EPZ1) wenigstens einen freitragenden und aus wenigstens einem piezoelektrischen Material gebildeten Träger (P3002) aufweist.

17. Integrierte Schaltung nach einem der Ansprüche 11 bis 16, wobei wenigstens ein piezoelektrisches Element (EPZ1) eine Monoblockeinheit (C300, C301, C302) mit mehreren Trägern aufweist, wobei jeder Träger freitragend und aus wenigstens einem piezoelektrischen Material gebildet ist.

18. Integrierte Schaltung nach Anspruch 16 oder 17 in Verbindung mit Anspruch 14, wobei der oder die freitragenden Träger in einem Abstand von der ersten Wand (C1) angebracht sind, um so einen durchbrochenen piezoelektrischen Teppich (P3000-P3001; P3010-P3015; P3020-P3022) zu bilden, der der ersten Wand (C1) gegenüber angeordnet ist, wobei die durchbrochenen Räume (ESP) des Teppichs eine Größe besitzen, die kleiner als die Größe jedes Objekts ist.

19. Integrierte Schaltung nach einem der Ansprüche 11 bis 15, wobei wenigstens ein piezoelektrisches Element eine durchbrochene Platte (C80) aufweist, die an ihren Rändern in wenigstens einem umschlossenen Raum befestigt ist, derart, dass sie sich in einer zu ihrer Oberfläche orthogonalen Richtung verformen kann, wobei die Platte aus wenigstens einem piezoelektrischen Material gebildet ist, wobei die durchbrochenen Räume der Platte eine Größe besitzen, die kleiner als die Größe jedes Objekts ist.

20. Integrierte Schaltung nach einem der Ansprüche 15, 18 und 19, wobei der durchbrochene Trägerteppich und die durchbrochene Platte (C80) einander gegenüber angeordnet sind, wobei das oder die Objekte (BL) zwischen dem Teppich und der Platte frei gelagert sind.

21. Integrierte Schaltung nach einem der Ansprüche 11 bis 20, wobei die Objekte (BL), die in dem umschlossenen Raum (CG) oder in wenigstens einem der umschlossenen Räume (CG) gelagert sind, gleiche oder unterschiedliche Größen besitzen.

22. Integrierte Schaltung nach Anspruch 21, wobei die Größe (D) jedes Objekts eine höchstens mikrometrische Größe ist.

23. Integrierte Schaltung nach einem der Ansprüche 11 bis 22, wobei jedes Objekt (BL) kartoffelförmig [franz.: patatoide] ist.

24. Integrierte Schaltung nach einem der Ansprüche 11 bis 23, wobei der oder die umschlossenen Räume über einer Metallisierungsebene (Mₙ) der integrierten Schaltung angeordnet sind.

25. Integrierte Schaltung nach einem der Ansprüche 11 bis 24, die ferner ein Speichermittel (CST) aufweist, das mit elektrischen Anschlussmitteln gekoppelt und konfiguriert ist, um die erzeugte Energie zu speichern.

26. Vorrichtung zur Erfassung des Eintretens eines Ereignisses, die eine integrierte Schaltung (CI) nach einem der Ansprüche 11 bis 25, die gestaltet ist, um ein ankommendes Signal (SIN), das aus dem Eintreten resultiert und imstande ist, das Versetzen in Relativbewegung hervorzurufen, zu empfangen, und Übertragungsmittel (MEM), die konfiguriert sind, um ein Ausgangssignal abzugeben, das ausgehend von der durch die Anschlussmittel der integrierten Schaltung abgegebenen Energie erzeugt wird, enthält.

27. Verfahren zur Fertigung einer integrierten Schaltung, **dadurch gekennzeichnet, dass** es eine Herstellung wenigstens eines dreidimensionalen umschlossenen Raums (CG), eine Herstellung wenigstens eines ersten piezoelektrischen Elements (EPZ1) in dem oder den umschlossenen Räumen und eine Herstellung wenigstens eines Objekts (BL), das in dem umschlossenen Raum oder jedem umschlossenen Raum frei gelagert ist, umfasst.

28. Verfahren nach Anspruch 27, das eine Herstellung eines aktiven Abschnitts (FEOL) der integrierten Schaltung und eine Herstellung eines Verbindungsabschnitts (BEOL) über dem aktiven Abschnitt und die Herstellung des wenigstens einen dreidimensionalen umschlossenen Raums (DB) umfasst, wobei die Herstellung des wenigstens einen ersten piezoelektrischen Elements (EPZ1) in dem oder den umschlossenen Räumen und die Herstellung des wenigstens einen Objekts (BL), das in dem umschlossenen Raum oder in jedem umschlossenen Raum frei gelagert ist, wobei Herstellung des Verbindungsabschnitts (BEOL) ausgeführt werden.

29. Verfahren nach Anspruch 28, bei dem das oder jedes erste piezoelektrische Element durch eine untere Schicht (C1), die eine untere Wand des entsprechenden umschlossnen Raums bildet, unterstützt wird.

30. Verfahren nach Anspruch 29, bei dem die Herstellung des oder jedes ersten piezoelektrischen Elements eine Bildung eines Stapels auf der unteren Schicht, der eine Unterstützungsschicht (C2) und eine Schicht (C3) aus einem piezoelektrischen Material enthält, eine Ätzung der Schicht aus piezoelektrischem Material, um so einen Teppich von Trägern zu bilden, und eine Teilätzung des Unterstützungsschicht, um so den Teppich freitragender Träger herzustellen, umfasst.

31. Verfahren nach Anspruch 30, bei dem die Herstellung des oder jedes ersten piezoelektrischen Elements (EP21) ferner eine Bildung eines Netzes metallisierter Bahnen (PSA, PSB) auf der Schicht aus piezoelektrischem Material umfasst.

32. Verfahren nach einem der Ansprüche 28 bis 31, bei dem die Herstellung des oder der Objekte Folgendes umfasst:
- eine Bildung einer Zwischenschicht (C5) auf dem piezoelektrischen Element,
- eine Bildung einer Zusatzschicht (C6) auf der Zwischenschicht (C5),
- eine Ätzung (GRV2) der Zusatzschicht Schicht, um so das oder die Objekte teilweise zu bilden,
- eine Bildung einer Ergänzungsschicht (C7) auf der geätzten Schicht,
- eine Bildung eines seitlichen Grabens (TR), der das erste piezoelektrische Element (EPZ1), die Zwischenschicht (C5), die geätzte Schicht (OB6) und die Ergänzungsschicht (C7) umgibt,
- eine Ausfüllung des Grabens (TR),
- eine Bildung einer oberen Schicht (C8) auf der Ergänzungsschicht (C7) und auf dem Graben (TR),
- eine Ätzung (GVR4) der oberen Schicht (C8), um so eine durchbrochene Schicht mit Öffnungen (OUV) zu bilden, deren Größe kleiner als die Größe der Objekte ist, und
- eine selektive Ätzung (GVR5) durch die Öffnungen (OUV) der Zwischenschicht (C5) und der Ergänzungsschicht (C7).

33. Verfahren nach Anspruch 32, bei dem die Herstellung des umschlossenen Raums ferner eine Bildung einer endgültigen Schicht (C9) auf der durchbrochenen oberen Schicht umfasst.

34. Verfahren nach einem der Ansprüche 28 bis 33, das ferner eine Herstellung wenigstens eines zweiten piezoelektrischen Elements (C80) gegenüber dem ersten piezoelektrischen Element umfasst.

35. Verfahren nach den Ansprüchen 32 und 34, bei dem die durchbrochene obere Schicht eine piezoelektrische Schicht (C80) ist, die das zweite piezoelektrische Element bildet, und die Bildung dieses zweiten piezoelektrischen Elements eine Bildung einer Hilfsschicht (C90) auf der piezoelektrischen Schicht, eine teilweise Ätzung der Hilfsschicht (C90), um so einen Hohlraum (CVT) über einem Abschnitt der piezoelektrischen Schicht und einen Halteabschnitt der piezoelektrischen Schicht um den Hohlraum zu bilden, und eine Bildung einer endgültigen Deckschicht (C10), die den Hohlraum (CVT) bedeckt, umfasst.
